# EUROPEAN PATENT SPECIFICATION

(11) **EP 1 144 498 B1**
(45) Date of publication and mention of the grant of the patent: **09.10.2002**
(21) Application number: 99937627.0
(22) Date of filing: 30.07.1999
(51) Int. Cl.: C08K 5/49, C08L 69/00

(54) **FLAME RETARDANT POLYMER BLENDS, AND METHOD FOR MAKING**
FLAMMHEMMENDE POLYMERMISCHUNGEN UND HERSTELLUNGSMETHODE
MELANGES DE POLYMERES IGNIFUGEANTS ET LEUR PROCEDE DE FABRICATION

(30) Priority: 31.08.1998 US 144687; 22.01.1999 US 235678; 08.07.1999 US 404456
(43) Date of publication of application: 17.10.2001
(73) Proprietor: GENERAL ELECTRIC COMPANY, Schenectady, NY 12345 (US)
(72) Inventor: BASTIAENS, Jos, Herman, Peter, NL-4611 JX Bergen op Zoom (NL); CAMPBELL, John, Robert, Clifton Park, NY 12065 (US); GOVERTS, Luc, Carlos, B-2320 Hoogstraten (BE)
(74) Representative: Szary, Anne Catherine, Dr.
(86) International application number: US9917227
(87) International publication number: WO00012609

(56) References cited:
- EP-A- 0 372 324
- EP-A- 0 728 811
- WO-A-93/22382
- WO-A-99/07779

## Description

This application is a continuation-in-part of copending application Serial No. 09/235,678, filed January 22, 1999.

### BACKGROUND OF THE INVENTION

This invention relates to blends of thermoplastic polymers, and more particularly to flame retardant blends having improved high temperature properties.

Improvement of the flame retardant properties of thermoplastic polymers such as polycarbonates has long been a goal of polymer compounders. Compounds containing phosphorus have been used in compositions with thermoplastic polymers to improve their flame resistance properties. Among the phosphorus compounds useful for this purpose are the bis(diaryl phosphate) esters of dihydroxyaromatic compounds, as illustrated by resorcinol bis(diphenyl phosphate), hydroquinone bis(diphenyl phosphate), and bisphenol A bis(diphenyl phosphate). Certain water soluble phosphoramides have also been used in the textile industry as flame retardant finishes for fabrics.

Phosphorus-containing compounds, however, often have undesirable effects on other physical properties of thermoplastic polymers. For example, phosphorus-containing compounds frequently have undesirable effects on the high temperature properties of polycarbonate and polycarbonate-containing blends, especially those blends also containing addition polymers such as acrylonitrile-butadiene-styrene copolymers (hereinafter referred to as "ABS copolymers"). Said undesirable effects may be demonstrated by a pronounced decrease in glass transition temperature (Tg) of one or more polymer phases. In addition, other physical properties of the blends, such as ductility, are sometimes adversely affected and may require improvement.

There are increasing demands from key industries, such as the electronics and computer industries, for polymer compositions possessing both flame retardant properties and higher heat resistance. Such compositions must also retain other key physical properties, such as adequate flow and impact strength, for applications such as computer housings, computer monitor housings, and printer housings. Another increasing demand is for materials that are rated in the Underwriter's Laboratory UL-94 test protocol as V-0, V-1, or V-2. It is therefore apparent that new resin compositions that meet these and other demands continue to be sought.

### SUMMARY OF THE INVENTION

The present invention meets that above-described needs by providing resin compositions comprising the following and any reaction products thereof:
a) at least one polyestercarbonate comprising structural units of the formula I: 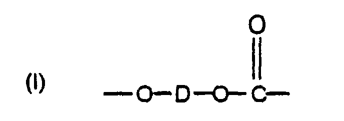 wherein D is a divalent aromatic radical; and repeating or recurring structural units of the formula II:

   (II) ―O―R1―O―D―

   wherein D has the meaning previously ascribed to it and R1 is at least one divalent moiety selected from those of the formulae III and IV: 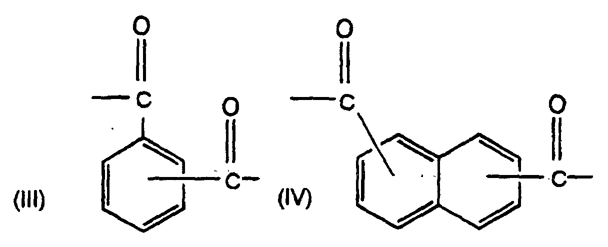
b) at least one addition polymer; and
c) at least one phosphoramide compound of the formula V: 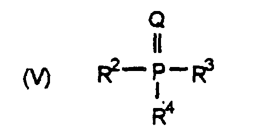 wherein Q is oxygen and R2 is an amine residue and, R3 and R4 are each independently an alkyloxy, alkylthio, aryloxy, or arylthio residue, or an aryloxy or arylthio residue containing at least one alkyl or halogen substitution, or mixture thereof; or an amine residue.

The present invention also provides articles made from the resin compositions. Furthermore, the present invention provides methods to make resin compositions having improved heat andlor processability over compositions known in the art.

### DETAILED DESCRIPTION OF THE INVENTION

In one embodiment, the composition of the present invention comprises a polyestercarbonate comprising structural units of the formula I 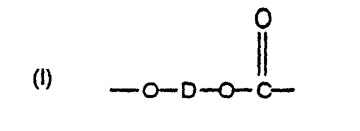 wherein D is a divalent aromatic radical; and repeating or recurring units of the formula II:

(II) ―O―R¹―O―D―

wherein D has the meaning previously ascribed to it and R¹ is at least one divalent moiety selected from those of the formulae III and IV:

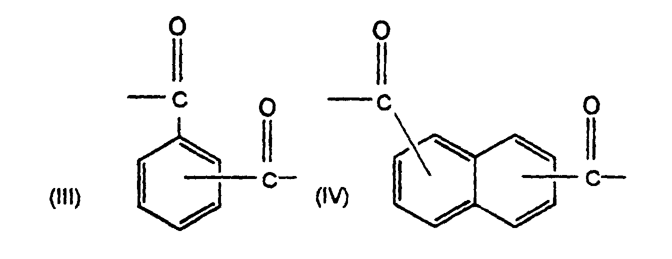

The polyestercarbonates which find use in the instant invention and the methods for their preparation are well known in the art as disclosed in, for example, U.S. Pat. Nos. 3,030,331; 3,169,121; 3,207,814; 4,194,038; 4,156,069; 4,238,596; 4,238,597; 4,487,896; 4,506,065, and in copending application Ser. No. 09/181,902, filed Oct. 29, 1998, and assigned to the same assignee as the instant application, all of which are hereby incorporated by reference. Among the properties characterizing these polymers is a relatively high distortion temperature under load (DTUL) as well as a relatively high impact strength as measured by a notched Izod test protocol.

The polyestercarbonates may generally be termed copolyesters containing carbonate groups, carboxylate groups, and aromatic carbocyclic groups in the polymer chain, in which at least some of the carboxylate groups and at least some of the carbonate groups are bonded directly to ring carbon atoms of the aromatic carbocyclic groups. These polyester-carbonates are, in general, prepared by reacting at least dihydric phenol, at least one difunctional carboxylic acid or reactive derivative of the acid such as the acid dihalide, and a carbonate precursor.

Suitable dihydric phenols for preparing polyestercarbonates include those represented by the formula VI :

(VI) HO―D―OH

wherein D is a divalent aromatic radical. Preferably, D has the structure of formula VII; 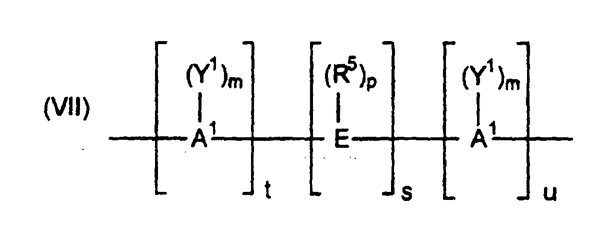 wherein A represents an aromatic group such as phenylene, biphenylene, naphthylene, etc. E may be an alkylene or alkylidene group such as methylene, ethylene, ethylidene, propylene, propylidene, isopropylidene, butylene, butylidene, isobutylidene, amylene, amylidene, isoamylidene, etc. Where E is an alkylene or alkylidene group, it may also consist of two or more alkylene or alkylidene groups connected by a moiety different from alkylene or alkylidene, such as an aromatic linkage; a tertiary amino linkage; an ether linkage; a carbonyl linkage; a silicon-containing linkage; or a sulfur-containing linkage such as sulfide, sulfoxide, sulfone, etc.; or a phosphorus-containing linkage such as phosphinyl, phosphonyl, etc. In addition, E may be a cycloaliphatic group (e.g., cyclopentylidene, cyclohexylidene, 3,3,5-trimethylcyclohexylidene, methylcyclohexylidene, 2-[2.2.1]-bicycloheptylidene, neopentylidene, cyclopentadecylidene, cyclododecylidene, adamantylidene, etc.); a sulfur-containing linkage, such as sulfide, sulfoxide or sulfone; a phosphorus-containing linkage, such as phosphinyl, phosphonyl; an ether linkage; a carbonyl group; a tertiary nitrogen group; or a silicon-containing linkage such as silane or siloxy. R⁵ represents hydrogen or a monovalent hydrocarbon group such as alkyl, aryl, aralkyl, alkaryl, or cycloalkyl. Y¹ may be an inorganic atom such as halogen (fluorine, bromine, chlorine, iodine); an inorganic group such as nitro; an organic group such as R⁵ above, or an oxy group such as OR; it being only necessary that Y¹ be inert to and unaffected by the reactants and reaction conditions used to prepare the polyestercarbonate. The letter m represents any integer from and including zero through the number of positions on A¹ available for substitution; p represents an integer from and including zero through the number of positions on E available for substitution; t represents an integer equal to at least one; s is either zero or one; and u represents any integer including zero.

In the dihydric phenol compound in which D is represented by formula VII above, when more than one Y substituent is present, they may be the same or different. The same holds true for the R⁵ substituent. Where s is zero in formula VII and u is not zero, the aromatic rings are directly joined with no intervening alkylidene or other bridge. The positions of the hydroxyl groups and Y¹ on the aromatic nuclear residues A¹ can be varied in the ortho, meta, or para positions and the groupings can be in vicinal, asymmetrical or symmetrical relationship, where two or more ring carbon atoms of the hydrocarbon residue are substituted with Y¹ and hydroxyl groups.

Some illustrative, non-limiting examples of dihydric phenols of formula VI include the dihydroxy-substituted aromatic hydrocarbons disclosed by name or formula (generic or specific) in U.S. Patent 4,217,438, which is incorporated herein by reference. Some preferred examples-of dihydric phenols include 4,4'-(3,3,5-trimethylcyclohexylidene)diphenol; 2,2-bis(4-hydroxyphenyl)propane (commonly known as bisphenol A); 2,2-bis(4-hydroxy-3,5-dimethylphenyl)propane; 2,4'-dihyroxydiphenylmethane; bis(2-hydroxyphenyl)methane; bis(4-hydroxyphenyl)methane; bis(4-hydroxy-5-nitrophenyl)methane; bis(4-hydroxy-2,6-dimethyl-3-methoxyphenyl)methane; 1,1-bis(4-hydroxyphenyl)ethane; 1,1-bis(4-hydroxy-2-chlorophenyl)ethane; 2,2-bis(3-phenyl-4-hydroxyphenyl)-propane; bis(4-hydroxyphenyl)cyclohexylmethane; 2,2-bis(4-hydroxyphenyl)-1-phenylpropane; resorcinol; C₁₋₃ alkyl-substituted resorcinols.

Suitable dihydric phenols also include those containing spirobiindane structural units such as represented by the formula VIII: 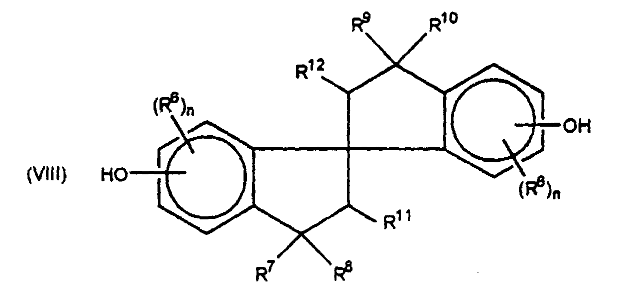 wherein each R⁶ is independently selected from monovalent hydrocarbon radicals and halogen radicals; each R⁷, R⁸, R⁹, and R¹⁰ is independently C₁₋₆ alkyl; each R¹¹ and R¹² is independently H or C₁₋₆ alkyl; and each n is independently selected from positive integers having a value of from 0 to 3 inclusive. The monovalent hydrocarbon radicals represented by R⁶ include alkyl radicals, cycloalkyl radicals, aryl radicals, aralkyl radicals, and alkaryl radicals. Alkyl radicals represented by R⁶ are preferably those containing from 1 to about 12 carbon atoms, and include branched alkyl radicals and straight chain alkyl radicals. Some illustrative non-limiting examples of these alkyl radicals include methyl, ethyl, propyl, isopropyl, butyl, tertiary-butyl, pentyl, neopentyl, and hexyl. Cycloalkyl radicals represented by R⁶ are preferably those containing from 3 to about 12 ring carbon atoms. Some illustrative non-limiting examples of these cycloalkyl radicals include cyclobutyl, cyclopentyl, cyclohexyl, methylcyclohexyl, cycloheptyl. Aryl radicals represented by R⁶ are preferably those containing from 6 to 12 ring carbon atoms. Some illustrative non-limiting examples of these aryl radicals include phenyl, biphenyl, naphthyl. Preferred aralkyl and alkaryl radicals represented by R⁶ are those containing from 7 to about 14 carbon atoms. These include, but are not limited to, benzyl, ethylphenyl, phenylbutyl, phenylpropyl, propylphenyl, and phenylethyl. The preferred halogen radicals represented by R⁶ are fluorine, chlorine and bromine.

In the dihydric phenol compound of formula VIII when more than one R⁶ substituent is present they may be the same or different. The relative positions of the hydroxyl groups and R⁶ on the aromatic nuclear residues may be varied in the ortho or meta positions. The position of each hydroxy group is independently at any unsubstituted site on each of the aromatic rings. More preferably each hydroxy group is independently in positions 5 or 6 and 5' or 6' of each aromatic ring. Most preferably each hydroxy group is in position 6 and 6' of each aromatic ring.

Preferably, each R⁶ is independently selected from chlorine, bromine, and lower alkyl radicals containing from 1 to about 5 carbon atoms, each R⁷, R⁸, R⁹, and R¹⁰ is independently C₁₋₆ alkyl; each R¹¹ and R¹² is independently H or C₁₋₆ alkyl; and each n is independently 0 to 3. More preferably, each R⁶ is independently selected from chlorine and lower alkyl radicals containing from 1 to about 3 carbon atoms, each R⁷, R⁸, R⁹, and R¹⁰ is independently C₁₋₂ alkyl; each R¹¹ and R¹² is independently H or C₁₋₂ alkyl; and each n is independently 0 to 2. Still more preferably, each R⁷, R⁸, R⁹, and R¹⁰ is methyl; each R¹¹ and R¹² is H; and each n is 0.

The spiro dihydric phenols of formula VIII are compounds that are known in the art and are commercially available or may be readily prepared by known methods. Methods of preparation include those described in U. S. Patent No. 4,701,566; and by R. F. Curtis and K. O. Lewis in Journal of the Chemical Society (England), 1962, p. 420; and by R. F. Curtis in Journal of the Chemical Society (England), 1962, p. 417. In one illustrative, non-limiting example these spiro dihydric phenols may be conveniently prepared by (i) reacting two moles of a phenolic compound with one mole of a carbonyl-containing compound such as acetone, and (ii) thereafter coreacting 3 moles of the product of (i) under acidic conditions to form the spiro dihydric phenol and 4 moles of a phenolic compound. The acids which may be utilized in (ii) can include such acids as anhydrous methane sulfonic acid, anhydrous hydrochloric acid, and the like.

The most preferred spiro dihydric phenol for forming polyestercarbonates suitable for use in the present invention is 6,6'-dihydroxy-3,3,3',3'-tetramethyl-1,1'-spirobiindane ("SBI"), in which n in formula VIII is 0 and the linkages with the rest of the polymer molecule are in a specific position on the aromatic rings.

In the preparation of suitable polyestercarbonates the dihydric phenols described above may be used alone or as mixtures of two or more different dihydric phenols. For reasons of availability and particular suitability for the purposes of this invention, a preferred dihydric phenol is 2,2-bis(4-hydroxyphenyl)propane ("BPA"), in which D in formula VII is bis(4-phenyl) isopropylidene.

In general, any difunctional carboxylic acid or a corresponding reactive derivative such as the acid dihalide can be conventionally used in the preparation of polyestercarbonates for the present invention. Typically, the carboxylic acids which may be used are aliphatic dicarboxylic acids, aliphatic-aromatic dicarboxylic acids, or aromatic dicarboxylic acids. The aromatic dicarboxylic acids or their reactive derivatives such as the aromatic acid dihalides are particularly preferred, as they produce aromatic polyestercarbonates which are most useful in the practice of the present invention. These dicarboxylic acids may be represented by the general formula IX:

(IX) HOOC―R¹³―COOH

wherein R¹³ represents an aromatic radical such as phenylene, naphthylene, biphenylene, substituted phenylene, etc.; two or more aromatic groups connected through non-aromatic linkages such as those defined by E in formula VII; or an aralkyl radical such as tolyl, xylyl, etc. or an alkaryl radical such as benzyl, etc. Particularly preferred aromatic dicarboxylic acids for preparation of polyestercarbonates are those comprising at least one dicarboxylic acid of formulas X and XI:

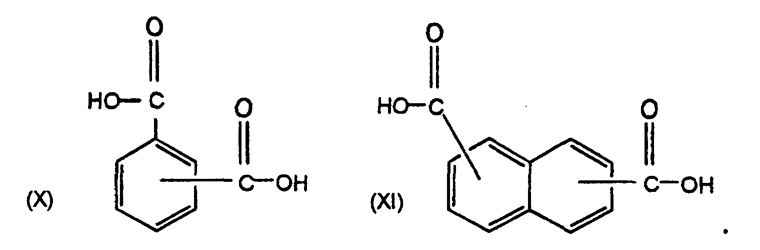

Some illustrative, non-limiting examples of suitable aromatic dicarboxylic acids include phthalic acid, isophthalic acid, terephthalic acid, homophthalic acid, o-, m-, and p-phenylenediacetic acid; and the polynuclear aromatic acids such as diphenic acid, 1,4-naphthalene dicarboxylic acid, 2,6-naphthalene dicarboxylic acid, and the like. These acids may be used either individually, or as a mixture of two or more different acids in the preparation of suitable polyestercarbonates.

The carbonate precursor may be a carbonyl halide, a carbonate ester or a haloformate. The carbonyl halides which can be employed herein are carbonyl chloride, carbonyl bromide and mixtures thereof. Typical of carbonate esters which may be employed herein are diphenyl carbonate, di(halophenyl)carbonates, such as di(chlorophenyl)carbonate, di(bromophenyl)carbonate, di(trichlorophenyl)carbonate, di(tribromophenyl)carbonate, etc.; di(alkylphenyl)carbonates such as di(tolyl)carbonate, etc., di(naphthyl)carbonate, di(chloronaphthyl)carbonate, phenyl tolyl carbonate, chlorophenyl chloronaphthyl carbonate, etc., or mixtures thereof. The haloformates suitable for use herein include bishaloformates of dihydric phenols (such as bischloroformates of hydroquinone, bisphenol A, etc.) or glycols (such as bishaloformates of ethylene glycol, neopentyl glycol, polyethylene glycol, etc.). Carbonyl chloride, also known as phosgene, is preferred.

The polyestercarbonates of the instant invention may be prepared by known processes such as interfacial polymerization or phase boundary separation, transesterification, solution polymerization, melt polymerization, transesterification, and the like. Various prior art polymerization processes are disclosed, for example, in U.S. Pat. Nos. 3,030,331; 3,169,121; and 3,207,814; and in copending application Ser. No. 09/181,902, filed Oct. 29, 1998. Although the processes may vary, several of the preferred processes typically involve dissolving or dispersing the reactants in a suitable water-immiscible solvent medium, and contacting the reactants with a carbonate precursor, such as phosgene, in the presence of a suitable catalyst and an aqueous caustic solution under controlled pH conditions. The most commonly used water-immiscible solvents include methylene chloride, 1,2-dichloroethane, chlorobenzene, toluene, and the like.

In an alternative method of preparation at least one dihydric phenol is reacted with at least one dicarboxylic acid or corresponding reactive derivative such as bis(acid halide) under alkaline conditions in a molar ratio such as to provide a hydroxy-terminated polyester oligomer. The degree of polymerization (DP) of the polyester oligomer is at least about 4, preferably at least about 10, more preferably at least about 20, and most preferably about 30 to about 150. The oligomer is then treated with dihydric phenol and carbonate precursor by standard methods to form a polyestercarbonate in which the DP of the carbonate blocks is generally at least about 10, preferably at least about 20, and most preferably about 50-200. In a preferred embodiment the dihydric phenol is resorcinol, the dicarboxylic acid source is a mixture of iso- and terephthaloyl chlorides (typically in an iso:tere ratio of about 5:95 to about 95:5), and the carbonate precursor is phosgene.

A molecular weight regulator, that is a chain stopper, is generally added to the reactants prior to or during contacting them with a carbonate precursor. Useful molecular weight regulators include, but are not limited to, monohydric phenols such as phenol, chroman-I, para-tertiarybutylphenol, and the like. Techniques for the control of molecular weight are well known in the art and may be used in the present process for controlling the molecular weight of the polyestercarbonate resins.

Advantageously a catalyst is added to the reaction mixture to promote the reaction. Representative catalysts include but are not limited to tertiary amines such as triethylamine, quaternary phosphonium compounds, quaternary ammonium compounds, and the like.

The temperature at which the polymerization reaction proceeds may vary from below 0°C, to above 100°C. Preferably, the temperature of polymerization varies from about -20°C to about 100°C, and most preferably at temperatures of from about room temperature (25°C) to about 50°C. Since the reaction is exothermic, the addition rate of carbonyl precursor, such as phosgene, may be used to control the reaction temperature. The amount of carbonyl precursor required will generally depend upon the amount of the dihydric phenols reactant added.

Acid acceptors may also be present during the reaction between dihydric phenols, dicarboxylic acids or their reactive derivatives, and the carbonate precursor. Examples of suitable acid acceptors include tertiary amines, alkali or alkaline earth metal hydroxides, and the like.

The polyestercarbonates which are particularly useful in the practice of the present invention are those derived from bisphenol A; terephthalic acid, isophthalic acid, or a mixture thereof, or terephthaloyl dichloride, isophthaloyl dichloride, or a mixture thereof; and phosgene. When a mixture of either terephthalic add and isophthalic acid, or terephthaloyl dichloride and isophthaloyl dichloride is utilized, the molar ratio (and weight ratio) of terephthalic units to isophthalic units is from about 5:95 to about 95:5, preferably from about 7:93 to about 50:50. The preferred polyestercarbonates have a weight average molecular weight of about 5,000 to about 100,000, more preferably of about 10,000 to about 65,000, and most preferably about 18,000 to about 36,000.

The proportions of reactants employed to prepare the polyestercarbonate resins will vary in accordance with the proposed use of the blends of the invention containing this product resin. In general, the amount of the ester units of formula II may be from about 10 to about 90 weight percent, relative to the carbonate units of formula I, and preferably about 60 to about 80 weight percent.

A single polyestercarbonate or a mixture of two or more different polyestercarbonates may be employed in the compositions of the present invention. For certain applications it is also contemplated to employ in the compositions a mixture comprising a at least one polyestercarbonate and at least one homopolycarbonate, homopolyester, or mixture thereof. For example, compositions comprising polyestercarbonates derived from bisphenol A-isophthalic/terephthalic acids may for some applications be advantageously combined with BPA homopolycarbonate. Preferably, the weight average molecular weight of the homopolycarbonate ranges from about 5,000 to about 100,000; more preferably from about 10,000 to about 65,000, still more preferably from about 16,000 to about 40,000, and most preferably from about 20,000 to about 36,000. Compositions comprising polyestercarbonates derived from bisphenol A-isophthalic/terephthalic acids may for some applications also be advantageously combined the polyarylate derived from copolymerizing 2:1:1 bisphenol A-isophthalic/terephthalic acids. Mixtures of homopolycarbonate and polyarylate may also be used in compositions containing polyestercarbonate.

In resinous compositions there is often an improvement in melt flow and/or other physical properties when one molecular weight grade of at least one resinous constituent is combined with a relatively lower molecular weight grade of similar resinous constituent. Illustrative, non-limiting examples include compositions containing at least one polycarbonate. For example, in a polycarbonate-containing blend there is often an improvement in melt flow when one molecular weight grade of polycarbonate is combined with a proportion of a relatively lower molecular weight grade of similar polycarbonate. Therefore, the present invention encompasses compositions comprising only one molecular weight grade of a particular resinous constituent and also compositions comprising two or more molecular weight grades of similar resinous constituent. When two or more molecular weight grades of similar resinous constituent are present, then the weight average molecular weight of the lowest molecular weight constituent is about 10% to about 95%, preferably about 40% to about 85%, and more preferably about 60% to about 80% of the weight average molecular weight of the highest molecular weight constituent. In one representative, non-limiting embodiment polycarbonate-containing blends include those comprising a polycarbonate with weight average molecular weight between about 28,000 and about 32,000 combined with a polycarbonate with weight average molecular weight between about 16,000 and about 26,000. When two or more molecular weight grades of similar resinous constituent are present, the weight ratios of the various molecular weight grades may range from about 1 to about 99 parts of one molecular weight grade and from about 99 to about 1 parts of any other molecular weight grades. A mixture of two molecular weight grades of a resinous constituent is often preferred, in which case the weight ratios of the two grades may range from about 99:1 to about 1:99, preferably from about 80:20 to about 20:80, and more preferably from about 70:30 to about 50:50. Since not all manufacturing processes for making a particular resinous constituent are capable of making all molecular weight grades of that constituent, the present invention encompasses compositions comprising two or more molecular weight grades of similar resinous constituent in which each of the similar resins is made by a different manufacturing process. In one particular embodiment the instant invention encompasses compositions comprising a polycarbonate made by an interfacial process in combination with a polycarbonate of different weight average molecular weight made by a melt transesterification process.

The presence of aromatic ester structural units of formula II in a copolymer also containing carbonate structural units of formula I is often observed to increase the Tg of said copolymer compared to the Tg of the corresponding homopolycarbonate containing structural units of formula I alone. For example, polyestercarbonates comprising BPA copolycarbonates containing ester structural units derived from isophthalic/terephthalic acids typically have higher Tg than do the corresponding BPA homopolycarbonates, as is disclosed, for example, in U.S. Pat. No. 4,506,065.

The addition polymer constituent of the blends of the invention may comprise any known addition homopolymer or copolymer. Addition homopolymers include, but are not limited to, homopolymers of unsaturated monomers such as olefins, polar-group-substituted olefins, non-polar-group-substituted olefins, dienes, alkenylaromatic compounds, and the like; and homopolymers of cyclic monomers such as cyclic carbonates, cyclic esters, cyclic amides, cyclic siloxanes, cyclic imides, cyclic etherimides, cyclic ethers, and the like. Addition copolymers include, but are not limited to, copolymers of two or more unsaturated monomers such as olefins, polar-group-substituted olefins, non-polar-group-substituted olefins, dienes, alkenylaromatic monomers, and the like; and copolymers of two or more cyclic monomers such as cyclic carbonates, cyclic esters, cyclic amides, cyclic siloxanes, cyclic imides, cyclic etherimides, cyclic ethers, and the like. Addition copolymers of two or more unsaturated monomers such as two olefin monomers; an olefin monomer and a polar-group-substituted olefin monomer; an alkenylaromatic monomer and a non-polar-group-substituted olefin monomer; and an alkenylaromatic monomer and a polar-group-substituted olefin monomer are preferred. Representative examples of such copolymers include styrene-acrylonitrile copolymers (SAN), and high impact polystyrene (HIPS), a genus of rubber-modified polystyrenes comprising blends and grafts wherein the rubber is a polybutadiene or a rubbery copolymer of about 70-98% styrene and 2-30% diene monomer. Also included among the SAN copolymers are acrylonitrile-butadiene-styrene (ABS) copolymers, which are typically grafts of styrene and acrylonitrile on a previously formed diene polymer backbone (e.g., polybutadiene or polyisoprene).

For the most part, rubber-modified thermoplastic resins based on addition polymers are preferred. Suitable rubber modified thermoplastic resins may comprise a discontinuous elastomeric substrate phase dispersed in a continuous rigid thermoplastic superstrate phase, wherein at least a portion of the rigid thermoplastic phase is chemically grafted to the elastomeric phase.

Suitable materials for use as the elastomeric phase are polymers having a Tg of less than or equal to 25°C, more preferably less than or equal to 0°C, and even more preferably less than or equal to -30°C. As referred to herein, the Tg of a polymer is the Tg value of polymer as measured by differential scanning calorimetry (heating rate 20°C/minute, with the Tg value being determined at the inflection point).

In a preferred embodiment, the elastomer phase comprises a polymer having repeating units derived from one or more ethylenically unsaturated monomers selected from conjugated diene monomers, non-conjugated diene monomers and C₁₋₁₂ alkyl (meth)acrylate monomers

Suitable conjugated diene monomers include, e.g., 1,3-butadiene; isoprene; 1,3-heptadiene; methyl-1,3-pentadiene; 2,3-dimethylbutadiene; 2-ethyl-1,3-pentadiene; 1,3-hexadiene; 2,4-hexadiene; dichlorobutadiene; bromobutadiene and dibromobutadiene as well as mixtures of conjugated diene monomers. In a preferred embodiment, the conjugated diene monomer is 1,3-butadiene. Suitable non-conjugated diene monomers include, e.g., ethylidene norbomene, dicyclopentadiene, hexadiene or phenyl norbomene.

As used herein, the term "C₁₋₁₂ alkyl" means a straight chain or branched alkyl substituent group having from 1 to 12 carbon atoms per group, and includes, e.g., methyl, ethyl, n-butyl, sec-butyl, t-butyl, n-propyl, iso-propyl, pentyl, hexyl, heptyl, octyl, nonyl, decyl, undecyl and dodecyl. As used herein, the terminology "(meth)acrylate monomers" refers collectively to acrylate monomers and methacrylate monomers. Suitable C₁₋₁₂ alkyl (meth)acrylate monomers include C₁₋₁₂ alkyl acrylate monomers, e.g., ethyl acrylate, butyl acrylate, isopentyl acrylate, n-hexyl acrylate, 2-ethyl hexyl acrylate, and their C₁₋₁₂ alkyl methacrylate analogs such as, e.g., methyl methacrylate, ethyl methacrylate, propyl methacrylate, iso-propyl methacrylate, butyl methacrylate, hexyl methacrylate, decyl methacrylate.

The elastomeric phase may, optionally, include up to about 25 percent by weight ("wt%") of one or more monomers selected from C₂₋₈ olefin monomers, vinyl aromatic monomers and monoethylenically unsaturated nitrile monomers.

As used herein, the term "C₂₋₈ olefin monomers" means a compound having from 2 to 8 carbon atoms per molecule and having a single site of ethylenic unsaturation per molecule. Suitable C₂₋₈ olefin monomers include, e.g., ethylene, propene, 1-butene, 1-pentene, heptene.

Suitable vinyl aromatic monomers include, e.g., styrene and substituted styrenes having one or more alkyl, alkoxyl, hydroxyl or halo substituent groups attached to the aromatic ring, including, e.g., α-methyl styrene, p-methyl styrene, vinyl toluene, vinyl xylene, trimethyl styrene, butyl styrene, chlorostyrene, dichlorostyrene, bromostyrene, p-hydroxystyrene, methoxystyrene and vinyl-substituted condensed aromatic ring structures, such as, e.g., vinyl naphthalene, vinyl anthracene, as well as mixtures of vinyl aromatic monomers.

As used herein, the term "monoethylenically unsaturated nitrile monomer" means an acyclic compound that includes a single nitrile group and a single site of ethylenic unsaturation per molecule and includes, e.g., acrylonitrile, methacrylonitrile, α- chloro acrylonitrile.

The elastomeric phase may, optionally, include a minor amount, e.g., up to 5 wt%, of repeating units derived from a polyethylenically unsaturated "crosslinking" monomer, e.g., butylene diacrylate, divinyl benzene, butene diol dimethacrylate, trimethylolpropane tri(meth)acrylate. As used herein, the term "polyethylenically unsaturated" means having two or more sites of ethylenic unsaturation per molecule.

The elastomeric phase may, particularly in those embodiments wherein the elastomeric phase has repeating units derived from alkyl (meth)acrylate monomers, include a minor amount, e.g., up to 5 wt% of repeating units derived from a polyethylenically unsaturated ''graftlinking'' monomer. Suitable graftlinking monomers include those monomers having a first site of ethylenic unsaturation with a reactivity similar to that of the ethylenically unsaturated monomers from which the respective substrate or superstrate is derived and a second site of ethylenic unsaturation with a relative reactivity that is substantially different from that of the ethylenically unsaturated monomers from which the elastomeric substrate phase is derived so that the first site reacts during synthesis of the elastomeric phase and the second site is available for later reaction under different reaction conditions, e.g., during synthesis of the rigid thermoplastic superstrate phase. Suitable graftlinking monomers include, e.g., allyl methacrylate, diallyl maleate, triallyl cyanurate.

In a preferred embodiment, the elastomeric phase comprises from about 60 to 100 wt% repeating units derived from one or more conjugated diene monomers and from 0 to about 40 wt% repeating units derived from one or more monomers selected from vinyl aromatic monomers and monoethylenically unsaturated nitrile monomers, such as, for example, a styrene-butadiene copolymer, an acrylonitrile-butadiene copolymer or a styrene-butadiene-acrylonitrile copolymer.

In an alternative preferred embodiment, the elastomeric phase comprises repeating units derived from one or more C₁₋₁₂ alkyl (meth)acrylate monomers. In a more highly preferred embodiment, the elastomeric phase comprises from 40 to 95 wt% repeating units derived from one or more C₁₋₁₂ alkyl (meth)acrylate monomers, more preferably from one or more monomers selected from ethyl acrylate, butyl acrylate and n-hexyl acrylate.

In a preferred embodiment, the elastomeric phase is made by aqueous emulsion polymerization in the presence of a free radical initiator, e.g., an azonitrile initiator, an organic peroxide initiator, a persulfate initiator or a redox initiator system, and, optionally, in the presence of a chain transfer agent, e.g., an alkyl mercaptan, and coagulated to form particles of elastomeric phase material. In a preferred embodiment, the emulsion polymerized particles of elastomeric phase material have a weight average particle size of about 50 to about 800 nm, more preferably, of from about 100 to about 500 nm, as measured by light transmission. The size of emulsion polymerized elastomeric particles may optionally be increased by mechanical or chemical agglomeration of the emulsion polymerized particles, according to known techniques.

The rigid thermoplastic resin superstrate phase comprises one or more thermoplastic polymers and exhibits a Tg of greater than 25°C, preferably greater than or equal to 90°C and even more preferably greater than or equal to 100°C.

In a preferred embodiment, the rigid thermoplastic phase comprises a polymer or a mixture of two or more polymers each having repeating units derived from one or more monomers selected from the group consisting of C₁₋₁₂ alkyl (meth)acrylate monomers, vinyl aromatic monomers and monoethylenically unsaturated nitrile monomers. Suitable C₁₋₁₂ alkyl (meth)acrylate monomers, vinyl aromatic monomers and monoethylenically unsaturated nitrile monomers are those set forth above in the description of the elastomeric phase.

In a highly preferred embodiment, the rigid thermoplastic phase comprises one or more vinyl aromatic polymers. Suitable vinyl aromatic polymers comprise at least 50 wt% repeating units derived from one or more vinyl aromatic monomers. In a preferred embodiment, the rigid thermoplastic phase comprises a vinyl aromatic polymer having first repeating units derived from one or more vinyl aromatic monomers and having second repeating units derived from one or more monoethylenically unsaturated nitrile monomers. In a more preferred embodiment, the rigid thermoplastic phase comprises from about 60% to about 90% by weight repeating units derived from styrene and from about 10% to about 40% by weight repeating units derived from acrylonitrile. In an alternative preferred embodiment, the rigid thermoplastic phase comprises repeating units derived from one or more C₁₋₁₂ alkyl (meth)acrylate monomers, and may, optionally, further comprise repeating units derived from one or more monomers selected from vinyl aromatic monomers and ethylenically unsaturated nitrile monomers. In another preferred embodiment, the rigid thermoplastic phase comprises greater than or equal to 50% by weight repeating units derived from one or more C₁₋₁₂ alkyl (meth)acrylate monomers, more preferably from one or more monomers selected from methyl methacrylate, ethyl methacrylate, propyl methacrylate, isopropyl methacrylate and butyl methacrylate.

The rigid thermoplastic phase is made according to known processes, e.g., mass polymerization, emulsion polymerization, suspension polymerization or combinations thereof, wherein at least a portion of the rigid thermoplastic phase is chemically bonded, i.e., "grafted" to the elastomeric phase via reaction with unsaturated sites present in the elastomeric phase. The unsaturated sites in the elastomeric phase are provided, e.g., by residual unsaturated sites in repeating units derived from a conjugated diene or by residual unsaturated sites in repeating units derived from a graftlinking monomer.

In a preferred embodiment, at least a portion of the rigid thermoplastic phase is made by an aqueous emulsion or aqueous suspension polymerization reaction in the presence of elastomeric phase and a polymerization initiator system, e.g., a thermal or redox initiator system. In an alternative preferred embodiment, at least a portion of the thermoplastic phase is made by a mass polymerization process, wherein particles of the material from which the elastomeric phase is to be formed are dispersed in a mixture of the monomers from which the rigid thermoplastic phase is to be formed, and the monomers of the mixture are then polymerized to form the rubber-modified thermoplastic resin.

The amount of grafting that takes place between the rigid thermoplastic phase and the elastomeric phase varies with the relative amount and composition of the elastomeric phase. In a preferred embodiment, from about 10 to about 90 wt%, preferably from about 30 to about 80 wt%, even more preferably from about 65 to about 80 wt% of the rigid thermoplastic phase is chemically grafted to the elastomeric phase and from about 10 to about 90 wt%, preferably from about 20 to about 70 wt%, more preferably from about 20 to about 35 wt% of the rigid thermoplastic phase remains free, i.e., non-grafted.

The rigid thermoplastic phase of the rubber modified thermoplastic resin may be formed: (i) solely by polymerization carried out in the presence of the elastomeric phase or (ii) by addition of one or more separately polymerized rigid thermoplastic polymers to a rigid thermoplastic polymer that has been polymerized in the presence of the elastomeric phase. In a preferred embodiment, less than about 10 parts by weight (pbw), more preferably less than about 5 pbw of separately polymerized rigid thermoplastic polymer is added per 100 pbw of the thermoplastic resin composition of the present invention. Most preferably no separately polymerized rigid thermoplastic polymer is added to the thermoplastic resin composition of the present invention.

Each of the polymers of the elastomeric phase and of the rigid thermoplastic resin phase of the rubber modified thermoplastic resin may, provided that the Tg limitation for the respective phase is satisfied, optionally include up to 10 wt% of repeating units derived from one or more other copolymerizable monomers such as, e.g., monoethylenically unsaturated carboxylic acids such as, e.g., acrylic acid, methacrylic acid, itaconic acid; hydroxy C₁₋₁₂ alkyl (meth)acrylate monomers such as, e.g., hydroxyethyl methacrylate; C₄₋₁₂ cycloalkyl (meth)acrylate monomers such as e.g., cyclohexyl methacrylate; (meth)acrylamide monomers such as e.g., acrylamide and methacrylamide; maleimide monomers such as, e.g., N-alkyl maleimides, N-aryl maleimides; maleic anhydride; vinyl esters such as, e.g., vinyl acetate and vinyl propionate. As used herein, the term "C₄₋₁₂ cycloalkyl" means a cyclic alkyl substituent group having from 3 to 12 carbon atoms per group, and the term "(meth)acrylamide" refers collectively to acrylamides and methacrylamides.

In a first preferred embodiment, the elastomeric substrate comprises repeating units derived from one or more conjugated diene monomers, and may, optionally, further comprise repeating units derived from one or more monomers selected from vinyl aromatic monomers and monoethylenically unsaturated nitrile monomers, and the thermoplastic superstrate comprises repeating units derived from one or more monomers selected from butadiene, vinyl aromatic monomers and monoethylenically unsaturated nitrile monomers. The preferred graft copolymer resins include, for example, acrylonitrile-butadiene-styrene resins commonly referred to as "ABS" resins.

Especially preferred are acrylonitrile-butadiene-styrene copolymers having greater than 30% by weight elastomeric substrate, preferably greater than about 45% by weight elastomeric substrate. The most preferred elastomeric substrates comprise polybutadiene or styrene-butadiene copolymer. Suitable acrylonitrile-butadiene-styrene copolymers may be produced by any method known in the art. In a preferred embodiment a suitable ABS is a high rubber graft acrylonitrile-butadiene-styrene copolymer produced in a process which includes an emulsion polymerization step. The phrase "high rubber graft" refers generally to graft copolymer resins wherein at least about 30% by weight, preferably at least about 45% by weight of the rigid polymeric phase is chemically bound or grafted to the elastomeric substrate phase. Suitable ABS-type high rubber graft copolymers are commercially available from, for example, GE Plastics, Inc. under the trademark BLENDEX and include grades 131, 336, 338, 360, and 415. In another preferred embodiment a suitable ABS is one produced in a process which includes a mass polymerization step, so-called bulk ABS. Bulk ABS may typically have inclusions of copolymerized styrene-acrylonitrile within the rubber particle dispersed phase.

In another preferred embodiment, the elastomeric substrate comprises repeating units derived from one or more C₁₋₁₂ alkyl (meth)acrylates and the rigid thermoplastic superstrate comprises repeating units derived from one or more monomers selected from vinyl aromatic monomers and monoethylenically unsaturated nitrile monomers. Such addition polymers include, for example, styrene-acrylate ("SA") high rubber graft copolymers and acrylonitrile-styrene-acrylate ("ASA") high rubber graft copolymers. Suitable ASA-type graft copolymers are commercially available from, for example, GE Plastics, Inc. under the trademark BLENDEX and include grade 975, 977, and 980.

In a yet another preferred embodiment, the elastomeric substrate comprises repeating units derived from one or more conjugated diene monomers and may, optionally, further comprise repeating units derived from one or more monomers selected from C₁₋₁₂ alkyl (meth)acrylate monomers, vinyl aromatic monomers and monoethylenically unsaturated nitrile monomers, and the thermoplastic superstrate comprises repeating units derived from one or more C₁₋₁₂ alkyl (meth)acrylate monomers and may, optionally, further comprise repeating units derived from one or more monomers selected from vinyl aromatic monomers and monoethylenically unsaturated nitrile monomers, such as, for example, methyl methacrylate-acrylonitrile-butadiene-styrene ("MABS") high rubber graft copolymers, methacrylate-butadiene-styrene ("MBS") high rubber graft copolymers. Suitable MBS-type graft copolymers are commercially available from Rohm and Haas Company under the trademark PARALOID and include grades BTA-733 and BTA-753, and from Kaneka Texas under the trademark KANE ACE and include grade B-56.

In another preferred embodiment, the elastomeric substrate comprises repeating units derived from one or more olefin monomers and may, optionally, further comprise repeating units derived from one or more non-conjugated diene monomers, and the thermoplastic superstrate comprises repeating units derived from one or more monomers selected from vinyl aromatic monomers and monoethylenically unsaturated nitrile monomers. Such addition polymers include, for example, acrylonitrile-ethylene-propylene-styrene ("AES") high rubber graft copolymers.

In still another preferred embodiment, the elastomeric substrate comprises repeating units derived from one or more C₁₋₁₂ alkyl (meth)acrylate monomers, and the thermoplastic superstrate comprises repeating units derived from one or more C₁₋₁₂ alkyl (meth)acrylate monomer, and include, for example, acrylic core-shell graft copolymers. Also included with the acrylic core-shell graft copolymers are butadiene-modified acrylic copolymers. Suitable acrylic-type graft copolymers are commercially available from Rohm and Haas Company under the trademark PARALOID and include grades KM 334 and KM 355, and from Elf Atochem as grade Dura-strength 200.

The phosphoryl compound comprises at least one compound of formula V: 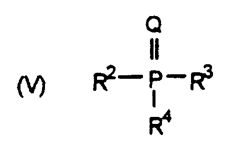 wherein Q is oxygen and R², R³, and R⁴ are each independently an alkyloxy, alkylthio, aryloxy, or arylthio residue, or an aryloxy or arylthio residue containing at least one alkyl or halogen substitution, or mixture thereof; or an amine residue at least one of R², R³, and R⁴ is an amine residue.

Particularly preferred in compositions of the present invention is at least one phosphoramide having a glass transition point of at least 0°C, preferably of at least 10°C, and most preferably of at least 20°C, of formula V, wherein R² is an amine residue, and R³ and R⁴ are independently an alkyloxy, alkylthio, aryloxy, or arylthio residue, or an aryloxy or arylthio residue containing at least one alkyl or halogen substitution, or mixture thereof; or an amine residue. Examples of such phosphoramides are disclosed in copending, commonly owned application Serial No. 09/144,687.

When a phosphoramide having a glass transition point of at least 0°C is used as a source of phosphorus in resin compositions, test specimens made from the compositions unexpectedly had a higher heat deflection temperature compared to test specimens made from compositions containing a triaryl organophosphate. Although the invention is not dependent upon mechanism, it is believed that selection of each of R², R³, and R⁴ residues that result in restricted rotation of the bonds connected to the phosphorus provide an increased glass transition point in comparison to similar phosphoramides with residues having a lesser degree of restriction. Residues having bulky substituents such as, for example, aryloxy residues containing at least one halogen, or preferably at least one alkyl substitution, result in phosphoramides having a higher glass transition point than similar phosphoramides without the substitution on the aryloxy residue. Likewise, residues wherein at least two of the R², R³, and R⁴ residues are interconnected, such as a neopentyl residue for the combination of the R³ and R⁴ residues, can lead to desired phosphoramides having a glass transition point of at least 0°C.

In a preferred embodiment, the phosphoramide comprises a phosphoramide having a glass transition temperature of at least 0°C, preferably of at least 10°C, and most preferably of at least 20°C, of the formula XII: 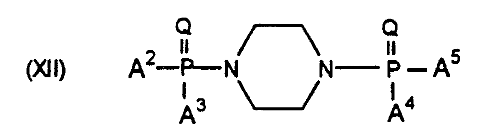 wherein each Q is oxygen or; and each of A²⁻⁵ is independently an alkyloxy, alkylthio, aryloxy, or arylthio residue, or an aryloxy or arylthio residue containing at least one alkyl or halogen substitution, or mixture thereof; or an amine residue. In an especially preferred embodiment of the invention, each Q is oxygen; and each of A²⁻⁵ in formula XII is a 2,6-dimethylphenoxy moiety, or each of A²⁻⁵ is a 2,4,6-trimethylphenoxy moiety. These phosphoramides are piperazine-type phosphoramides. In the above formula wherein each Q is oxygen, and each A is a 2,6-dimethylphenoxy moiety, the glass transition temperature of the corresponding phosphoramide is 62°C and the melting point is 192°C. Conversely, in the above formula wherein each Q is oxygen, and each A is phenoxy, the glass transition temperature of the corresponding phosphoramide is 0°C and the melting point is 188°C. It was unexpected that the glass transition temperature would be so high (i.e. 62°C) for the phosphoramide of formula XII wherein each Q is oxygen, and each A is a 2,6-dimethylphenoxy moiety as compared to the corresponding phosphoramide of formula XII wherein each Q is oxygen, and each A is a phenoxy moiety (i.e. 0°C), especially since the melting points for the two phosphoramides differ by only 4°C. For comparison, the glass transition temperature of tetraphenyl resorcinol diphosphate is -38°C. It is also possible to make phosphoramides with intermediate glass transition temperatures by using a mixture of various substituted and non-substituted aryl moieties within the phosphoramide.

In another preferred embodiment, the phosphoramide comprises a phosphoramide having a glass transition temperature of at least about 0°C, preferably of at least 10°C, and most preferably of at least 20°C, of the formula XIII: 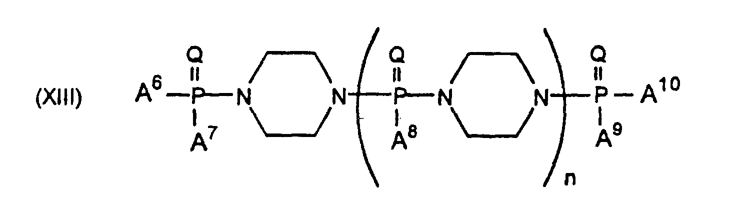 wherein each Q is oxygen or ; and each of A⁶⁻¹⁰ is independently an alkyloxy, alkylthio, aryloxy, or arylthio residue, or an aryloxy or arylthio residue containing at least one alkyl or halogen substitution, or mixture thereof; or an amine residue; and n is from O to about 5. In a more preferred embodiment, each Q is oxygen, and each A⁶⁻¹⁰ moiety is independently phenoxy, 2,6-dimethylphenoxy, or 2,4,6-trimethylphenoxy, and n is from 0 to about 5.

In another embodiment of the invention the phosphoramide comprises a phosphoramide having a glass transition temperature of at least 0°C, preferably of at least 10°C, and most preferably of at least 20°C, of the formula XIV : 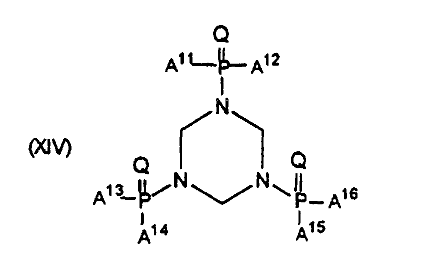 wherein each Q is oxygen ; and each of A¹¹⁻¹⁶ is independently an alkyloxy, alkylthio, aryloxy, or arylthio residue, or an aryloxy or arylthio residue containing at least one alkyl or halogen substitution, or mixture thereof; or an amine residue. In a more preferred embodiment, each Q is oxygen, and each A¹¹⁻¹⁶ moiety is independently phenoxy, 2,6-dimethylphenoxy, or 2,4,6-trimethyl-phenoxy.

In another embodiment of the invention the phosphoramide comprises a phosphoramide having a glass transition temperature of at least 0°C, preferably of at least 10°C, and most preferably of at least 20°C, of the formula XV: 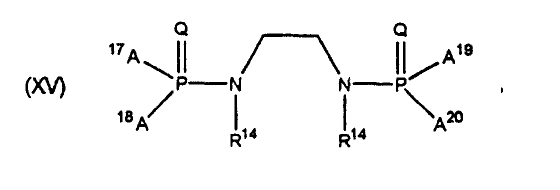 wherein each Q is oxygen ; each of A¹⁷⁻²⁰ is independently an alkyloxy, alkylthio, aryloxy, or arylthio residue, or an aryloxy or arylthio residue containing at least one alkyl or halogen substitution, or mixture thereof; or an amine residue; and each R¹⁴ is an alkyl radical, or both R¹⁴ radicals taken together are an alkylidene or alkyl-substituted alkylidene radical. In a preferred embodiment, each Q is oxygen; both R¹⁴ radicals taken together are an unsubstituted (CH₂)ₘ alkylidene radical, wherein m is 2-10; and each A¹⁷⁻²⁰ moiety is independently phenoxy, 2,6-dimethylphenoxy, or 2,4,6-trimethylphenoxy. In a more preferred embodiment, each Q is oxygen; each R¹⁴ is methyl; and each A¹⁷⁻²⁰ moiety is independently phenoxy, 2,6-dimethylphenoxy, or 2,4,6-trimethylphenoxy.

In another embodiment of the invention, the phosphoramide comprises a phosphoramide having a glass transition point of at least 0°C, preferably of at least 10°C, and most preferably of at least 20°C, of the formula V: 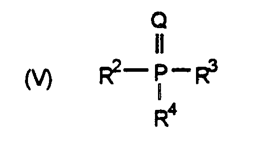 wherein Q is oxygen and R² is of the formula XVI: 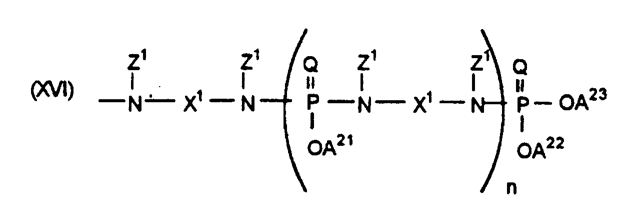 wherein each Q is oxygen; each of A²¹⁻²³ is independently an alkyloxy, alkylthio, aryloxy, or arylthio residue, or an aryloxy or arylthio residue containing at least one alkyl or halogen substitution, or mixture thereof; or an amine residue; each Z¹ is an alkyl radical, aromatic radical, or aromatic radical containing at least one alkyl or halogen substitution or mixture thereof; each X¹ is an alkylidene radical, aromatic radical, or aromatic radical containing at least one alkyl or halogen substitution or mixture thereof; n is from 0 to about 5; and R³ and R⁴ are each independently an alkyloxy, alkylthio, aryloxy, or arylthio residue, or an aryloxy or arylthio residue containing at least one alkyl or halogen substitution, or mixture thereof; or an amine residue. In a preferred embodiment, each Q is oxygen; each A²¹⁻²³ moiety is independently phenoxy, 2,6-dimethylphenoxy, or 2,4,6-trimethylphenoxy; each Z¹ is methyl or benzyl; each X¹ is an alkylidene radical containing 2-24 carbon atoms; n is from 0 to about 5; and R³ and R⁴ are each independently phenoxy, 2,6-dimethylphenoxy, or 2,4,6-trimethylphenoxy.

In another embodiment of the invention, the phosphoramide comprises a phosphoramide having a glass transition point of at least 0°C, preferably of at least 10°C, and most preferably of at least 20°C, of the formula V: 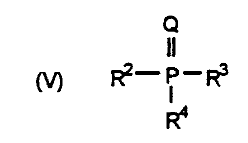 wherein Q is oxygen; and R² is of the formula XVII: 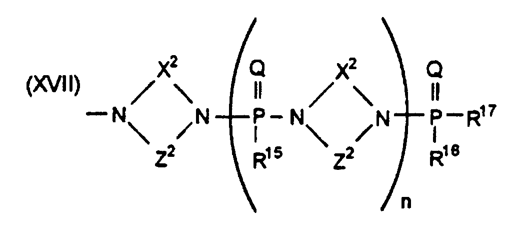 wherein each Q is oxygen; each X² is an alkylidene or alkyl-substituted alkylidene residue, aryl residue, or alkaryl residue; each Z² is an alkylidene or alkyl-substituted alkylidene residue; each of R¹⁵, R¹⁶, and R¹⁷ is independently an alkyloxy, alkylthio, aryloxy, or arylthio residue, or an aryloxy or arylthio residue containing at least one alkyl or halogen substitution, or mixture thereof; or an amine residue; n is from 0 to about 5; and R³ and R⁴ are each independently an alkyloxy, alkylthio, aryloxy, or arylthio residue, or an aryloxy or arylthio residue containing at least one alkyl or halogen substitution, or mixture thereof; or an amine residue. In a preferred embodiment, each Q is oxygen; each X² is an alkylidene or alkyl-substituted alkylidene residue; each Z² is an alkylidene or alkyl-substituted alkylidene residue; each of R³, R⁴, R¹⁵, R¹⁶, and R¹⁷ is independently phenoxy, 2,6-dimethylphenoxy, or 2,4,6-trimethyl-phenoxy; and n is from 0 to 5. In a more preferred embodiment, each Q is oxygen; each X² and Z² is independently an unsubstituted alkylidene residue of the form (CH₂)ₘ, wherein m is 2-10; each of R³, R⁴, R¹⁵, R¹⁶, and R¹⁷ is independently phenoxy, 2,6-dimethylphenoxy, or 2,4,6-trimethyl-phenoxy; and n is from 0 to about 5. In an especially preferred embodiment, the phosphoramide is derived from piperazine (i.e. X² and Z² are each -CH₂-CH₂-).

In another preferred embodiment, the phosphoramide comprises a cyclic phosphoramide having a glass transition point of at least 0°C, preferably of at least 10°C, and most preferably of at least 20°C of the formula XVIII: 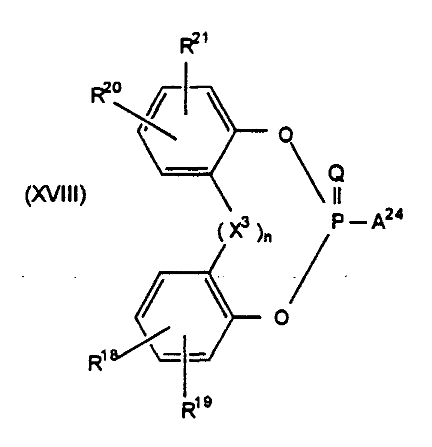 wherein each of R¹⁸⁻²¹ is independently a hydrogen or an alkyl radical, X³ is an alkylidene radical, Q is oxygen or sulfur, and A²⁴ is a group derived from a primary or secondary amine having the same or different radicals that can be aliphatic, alicyclic, aromatic, or alkaryl, or A²⁴ is a group derived from a heterocyclic amine, or A²⁴ is a hydrazine compound. Preferably Q is oxygen. It should be noted that when n is 0, then the two aryl rings are linked together at that site (i.e. where X³ is absent) by a single bond in the positions ortho,ortho' to the phosphoryl bonds.

In another preferred embodiment, the phosphoramide comprises a bis(cyclic) phosphoramide having a glass transition point of at least 0°C, preferably of at least 10°C, and most preferably of at least 20°C of the formula XIX: 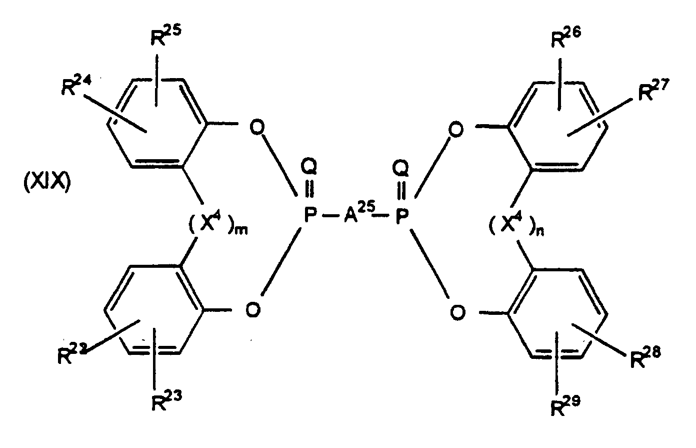 wherein Q is oxygen; each of R²²⁻²⁹ is independently a hydrogen or an alkyl radical; X⁴ is an alkylidene radical; m and n are each independently 0 or 1; and A²⁵ is 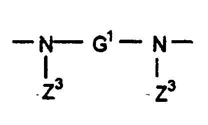 wherein G¹ is sulfur, an alkylidene radical, alkyl-substituted alkylidene radical, aryl radical, or alkaryl radical, and each Z³ is independently an alkyl radical, an aryl radical, or an aryl radical containing at least one alkyl or halogen substitution, or mixture thereof; or wherein A²⁵ is 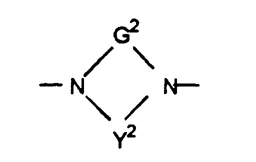 wherein G² is alkylidene, aryl, or alkaryl, and Y² is alkylidene or alkyl-substituted alkylidene. Preferred phosphoramides are those wherein Q is oxygen, A²⁵ is a residue of piperazine, and the phosphoramide has a plane of symmetry through A²⁵. Highly preferred phosphoramides include those wherein Q is oxygen; A²⁵ is a residue of piperazine; the phosphoramide has a plane of symmetry through A²⁵; at least one R substituent on each aryl ring is a methyl adjacent to the oxygen substituent; n and m are each 1; and X⁴ is CHR³⁰ wherein R³⁰ is a hydrogen or an alkyl residue of from about 1 to about 6 carbon atoms. It should be noted that when either or both of m or n is 0, then the two aryl rings are linked together at that site (i.e. where X⁴ is absent) by a single bond in the positions ortho,ortho' to the phosphoryl bonds.

It should be noted that in the descriptions herein, the words "radical" and "residue" are used interchangeably, and are both intended to designate an organic moiety. For example, alkyl radical and alkyl residue are both intended to designate an alkyl moiety. The term "alkyl" as used in the various embodiments of the present invention is intended to designate both normal alkyl, branched alkyl, aralkyl, and cycloalkyl radicals. Normal and branched alkyl radicals are preferably those containing from 1 to about 12 carbon atoms, and include as illustrative non-limiting examples methyl, ethyl, propyl, isopropyl, butyl, tertiary-butyl, pentyl, neopentyl, and hexyl. Cycloalkyl radicals represented are preferably those containing from 3 to about 12 ring carbon atoms. Some illustrative non-limiting examples of cycloalkyl radicals include cyclobutyl, cyclopentyl, cyclohexyl, methylcyclohexyl, cycloheptyl. Preferred aralkyl radicals are those containing from 7 to about 14 carbon atoms; these include, but are not limited to, benzyl, phenylbutyl, phenylpropyl, and phenylethyl. Aryl radicals used in the various embodiments of the present invention are preferably those containing from 6 to 12 ring carbon atoms. Some illustrative non-limiting examples of aryl radicals include phenyl, biphenyl, naphthyl. The preferred halogen radicals used in the various embodiments of the present invention are chlorine and bromine.

Phosphoramides of useful molecular structure are preferably prepared by the reaction of a corresponding amine such as, for example, piperazine or N,N'-dimethylethylenediamine with a diaryl chlorophosphate of the formula (aryl-O)₂POCl in the presence of a tertiary amine. This method of preparation is described in Talley, *J. Chem. Eng. Data*, 33, 221-222 (1988) and leads to specific phosphoramide compounds without repeating units. Alternatively, phosphoramides may be prepared by the reaction of the corresponding amine with P(O)Cl₃ in the presence of a tertiary amine, with the desired hydroxyl- or thiohydroxy-containing compound added simultaneously or subsequently to the addition of the amine. Addition of a diamine or triamine to P(O)Cl₃ with simultaneous or subsequent addition of the hydroxyl or thiohydroxy-containing compound is believed to lead to repeating units of phosphoramide, often of 1 to about 5 phosphoramide linkages per compound. Similarly, addition of a diamine or triamine to a monosubstituted phosphoryl- or thiophosphoryl dichloride with simultaneous or subsequent addition of hydroxyl- or thiohydroxy-containing compound is also believed to lead to repeating units of phosphoramide. P(S)Cl₃ may be substituted for P(O)Cl₃ in the above preparations to provide suitable phosphoramides.

The resinous compositions of this invention may contain a flame retarding amount (defined below) and/or processability enhancing amount of at least one phosphoryl compound, for example, a phosphate ester, a phosphoramide, or a mixture of two or more phosphate esters, or two or more phosphoramides, or a phosphoramide and at least one non-polymeric or polymeric phosphorus additive selected from the group consisting of organic phosphate esters and thiophosphate esters. Preferred phosphorus additives are non-polymeric organic phosphate esters including, for example, alkyl phosphate esters, mixed alkyl-aryl phosphate esters, and aryl phosphate esters, including, but not limited to, resorcinol-based phosphate esters, and bisphenol-based phosphate esters known in the art. The resinous compositions preferably contain essentially a single phosphoryl compound, and most preferably a single phosphoramide.

Flame retardancy is preferably measured according to the Underwriters' Laboratory UL-94 protocol (ASTM procedure D3801). In this test, the desirable V-0 rating is given to polymers of which specimens do not burn with flaming combustion for more than 10 seconds after application of a test flame, and specimens do not burn with flaming combustion for a time exceeding 50 seconds upon 2 flame applications to each of 5 specimens; i.e., the total "flame-out time" (FOT) for said samples is not greater than 50 seconds. A flame retarding amount is an amount effective to render the composition at least a V-2 rating, preferably at least a V-1 rating, and most preferably a V-0 rating after testing in the UL-94 protocol when measured on a test specimen of 0.03 to 0.125 inch* in thickness by 0.5 inch by 5 inch, preferably 0.125 inch in thickness by 0.5 inch by 5 inch, more preferably 0.06 inch in thickness by 0.5 inch by 5 inch, and most preferably 0.03 inch in thickness by 0.5 inch by 5 inch dimensions. Enhanced processability can be determined, for example, as a reduction in extruder torque during compounding, reduced pressure in injection molding, reduced viscosity, and/or decreased cycle time.
*1 inch = 25.4 mm

For the most part, the compositions of the invention comprise about 55-95% by weight polyestercarbonate portion and about 5-45% addition polymer, based on total resinous constituents. It should be understood that the proportion of polyestercarbonate also includes any additional homopolycarbonate, polyarylate or mixture thereof, when present. The phosphoryl compound is present typically in the range of about 0.1-5 parts of phosphorus per 100 parts of resinous materials (phr), all percentages herein being by weight. More preferably, the phosphoryl compound is present in a flame retarding amount, typically in the range of about 0.25-2.5 parts by weight of phosphorus per 100 parts of resinous materials. The total amount of phosphoryl compound is most often in the range of about 1-50 phr, preferably about 5-35 phr.

In one embodiment of the present invention halogen-containing flame retardants or other halogen-containing species may also be present in the compositions. In many resinous compositions, the combination of a halogen-containing flame retardant and a phosphoryl compound, particularly a phosphoramide having a glass transition point of at least 0°C, provides both suitable flame retardant properties and unexpectedly improved high temperature properties (such as measured, for example, by HDT or Tg of a resinous phase). Illustrative, non-limiting examples of halogen-containing flame retardants or halogen-containing species include brominated flame retardants and phosphoramides containing halogenated aromatic substituents. Due to environmental regulations chlorine-free and bromine-free compositions may be preferred for certain applications. Therefore, in a preferred embodiment the present invention includes compositions which are essentially free of chlorine and bromine. In this context essentially free means that no chlorine- or bromine-containing species has been added to the compositions in their formulation. In another of its embodiments the present invention includes articles obtained from said chlorine-free or bromine-free compositions.

The compositions of the invention may also contain other conventional additives including stabilizers, inhibitors, plasticizers, fillers, mold release agents and anti-drip agents. The latter are illustrated by tetrafluoroethylene polymers or copolymers, including mixtures with such other polymers as polystyrene-co-acrylonitrile.

The compositions of this invention are characterized by superior high temperature properties, as demonstrated by Tg values above those of comparable blends not containing ester structural units derived from formula II. They also often possess advantageously high heat deflection temperatures.

Preferred compositions of the invention contain a phosphoramide with Tg of at least 0°C, preferably of at least 10°C, and most preferably of at least 20°C. Such compositions exhibit improved high temperature properties. This is demonstrated by the fact that the decrease in Tg exhibited as a result of the incorporation of such a phosphoramide in the composition is substantially less than the corresponding decrease exhibited in blends containing, for example, phosphate esters such as bis(diaryl phosphates) of dihydroxyaromatic compounds. This is evident when a phosphoramide is compared to the organic phosphate ester in amounts suitable to provide enhanced flame resistance when measured, for example, in the UL-94 test procedure. In the case of phase-separated blends such as polycarbonate-ABS blends, the decrease in Tg is noted in the polycarbonate phase.

Experience has shown that the flame retarding properties of a phosphoryl-based compound as an additive in a resinous composition are generally proportional to the amount of phosphorus in the composition rather than to the amount of the compound itself. Thus, equal weights of two additives having different molecular weights but the same flame retarding properties may produce different UL-94 results, but amounts of the two additives which contribute the same proportion of phosphorus to the resinous composition will produce the same UL-94 results. On the other hand, other physical properties such as high temperature resistance are dependent on the amount of the compound itself and relatively independent of the phosphorus proportion therein. For this reason, the dependence of flame retarding and high temperature resistance of compositions containing two phosphorus-based compounds may not follow the same pattern.

It has been shown, however, with respect to the preferred phosphoramides employed according to the present invention that their superior properties of flame retardance and high temperature resistance are consistent. Thus, for example, proportions of resorcinol bis(di-2,6-xylyl phosphate) effective to confer a suitable flame-out time on certain resinous compositions are simitar to those produced by a typical bis(2,6-xylyl)-phosphoramide at an essentially equivalent level of phosphorus, but the bisphosphoramide has a substantially lower tendency to decrease heat deflection temperature (HDT) despite the slightly greater amount of the bulk additive.

It should be clear that the present invention also affords methods to increase the heat distortion temperature of flame resistant compositions containing an amount of at least one phosphoryl compound effective to render the composition a flame rating of at least V-2, preferably of at least V-1, most preferably V-0, in the UL-94 protocol, wherein the method comprises combining at least one polyestercarbonate comprising structural units of formulas I and II, at least one addition polymer, and at least one phosphoryl compound of the formula V. In a preferred embodiment the invention also affords methods to increase the heat distortion temperature of chlorine-free and bromine-free, flame resistant compositions as described in the previous sentence. The method may be used to increase the heat distortion temperature of compositions containing essentially a single phosphoryl compound or a mixture of two or more different types of phosphoryl compound. Compositions containing essentially a single phosphoryl compound are often preferred. The preferred phosphoryl compounds in most instances is N,N'-bis[di-(2,6-xylyl)phosphoryl]- piperazine, hereinafter "XPP", with XPP often being especially preferred because of its improved high temperature properties. It should also be clear that the present invention includes compositions made by the methods as well as articles made from the compositions.

Preparation methods for the compositions of the invention are typical of those employed for resinous blends. They may include such steps as dry blending followed by melt processing, the latter operation frequently being performed under continuous conditions as by extrusion. Following melt processing, the compositions are molded into test specimens by conventional means such as injection molding.

The addition of at least one phosphoryl compound or mixture of at least one phosphoryl compound and at least one phosphorus additive to the compositions of the present invention may be by mixing all of the blend components together prior to melt processing. Alternatively, any or a combination of any of the phosphorus-containing species, particularly a phosphoramide or a phosphorus additive, may be combined with at least one resinous blend component as a concentrate in a prior processing step. Such concentrates are often made by melt processing. The concentrate may then be combined with the remaining blend components.

The various embodiments of the invention are inclusive of simple blends comprising at least one polyestercarbonate comprising structural units of formulas I and II, at least one addition polymer, and at least one phosphoryl compound of the formula V, and also of compositions in which one or more of said materials has undergone chemical reaction, either by itself or in combination with another blend component. When proportions are specified, they apply to the originally incorporated materials rather than those remaining after any such reaction.

In another of its embodiments the present invention comprises articles of manufacture made from the instantly disclosed compositions. Said articles can be made by any convenient means known in the art. Typical means include, but are not limited to, injection molding, thermoforming, blow molding, and calendering. Especially preferred articles include indirect and direct wound deflection yokes for all cathode ray tube applications including television and computer monitors, slit type deflection yokes, mold coil deflection yokes, television backplates, docking stations, pedestals, bezels, pallets, electronic equipment such as switches, switch housings, plugs, plug housings, electrical connectors, connecting devices, sockets; housings for electronic equipment such as television cabinets, computer housings, including desk-top computers, portable computers, lap-top computers, palm-held computers; monitor housings, printer housings, keyboards, FAX machine housings, copier housings, telephone housings, mobile phone housings, radio sender and/or receiver housings, lights and lighting fixtures, battery chargers, battery housings, antenna housings, transformers, modems, cartridges, network interface devices, circuit breakers, meter housings, panels for wet and dry appliances such as dishwashers, clothes washers, clothes dryers, refrigerators; heating and ventilation enclosures, fans, air conditioner housings, cladding and seating for indoor and outdoor application such as public transportation including trains, subways, buses; automotive electrical components.

The invention is illustrated by the following examples. All parts and percentages are by weight. HDT values were determined at (264 psi) 1820 kPa according to ASTM procedure D648. Notched Izod impact strength values were determined according to ASTM procedure D256. Elongation (%) after exposure to solvent (ESCR) was determined on Type I tensile bars which had been mounted in a strain jig at 1% strain and exposed to 88:12 (vol/vol) hexane/ethyl acetate for 5 minutes at ambient temperature.

### Comparative EXAMPLES 1-2

A blend of 70 wt.% bisphenol A homopolycarbonate, 9 wt.% of a commercially available high rubber graft ABS copolymer, 8.5 wt.% of a commercially available SAN copolymer, and a flame-retarding amount of RDP (resorcinol bis(diphenyl phosphate) (11.5 phr corresponding to 1.24 phr phosphorus) was prepared by blending in a Henschel mixer followed by extrusion on a twin screw extruder, and was molded into test specimens. A control blend (Example 2) also containing homopolycarbonate-ABS-SAN but containing no flame retardant was prepared under identical conditions. The control blend had somewhat different proportions of polymers than the product of Example 1, but that is insignificant for comparison purposes since its only role was to serve as a baseline for the Tg of the polycarbonate phase. Each blend also contained conventional additives including 0.5 part of a polytetrafluoroethylene dispersion in styrene-acrylonitrile copolymer as an anti-drip agent, which were not considered in determining proportions. The notched Izod impact strength (NI) and % elongation after exposure to solvent (ESCR) were determined for the test specimens of Example 1. The Tg of the polycarbonate phase for test specimens of each example was determined. Comparison of Example 1 with the control Example 2 shows that a very significant loss in the polycarbonate Tg occurs with the addition of the required amount of RDP.

**TABLE 1**

| Component | 1 | 2 |
|---|---|---|
| Polycarbonate, wt.% | 70 | 73.6 |
| RDP, phr | 11.5 | 0 |
| | | |
| Polycarbonate phase Tg (°C) | 104 | 148 |
| ESCR (% elong) | 56 | |
| INI (ft-lbs/in) | 8 | |

### EXAMPLES 3-12

Examples 3-12 were prepared in a similar manner to Example 1. These Examples each contained a polyestercarbonate (PCE) derived from bisphenol A-isophthalic/terephthalic acids and containing about 60 wt.% ester units and about 40 wt.% carbonate units. The polyestercarbonate was combined with various amounts of BPA homopolycarbonate (PC) to provide various weight ratios of ester/carbonate units. Blends of polyestercarbonate with or without homopolycarbonate were prepared containing 9 wt.% of a commercially available high rubber graft ABS copolymer, 8.5 wt.% of a commercially available SAN copolymer, and a flame-retarding amount of either RDP (11.5 phr corresponding to 1.24 phr phosphorus), or XPP (13.5 phr corresponding to 1.26 phr phosphorus). Each blend also contained conventional additives including 0.5 part of a polytetrafluoroethylene dispersion in styrene-acrylonitrile copolymer as an anti-drip agent, which were not considered in determining proportions. The notched Izod impact strength (NI) and tensile elongation after exposure to solvent (ESCR) were determined for the test specimens of Example 1. The Tg of the polycarbonate phase for test specimens of each example was determined. The results are shown in Table II. All ester/carbonate (es/ca) ratios are in wt.%.

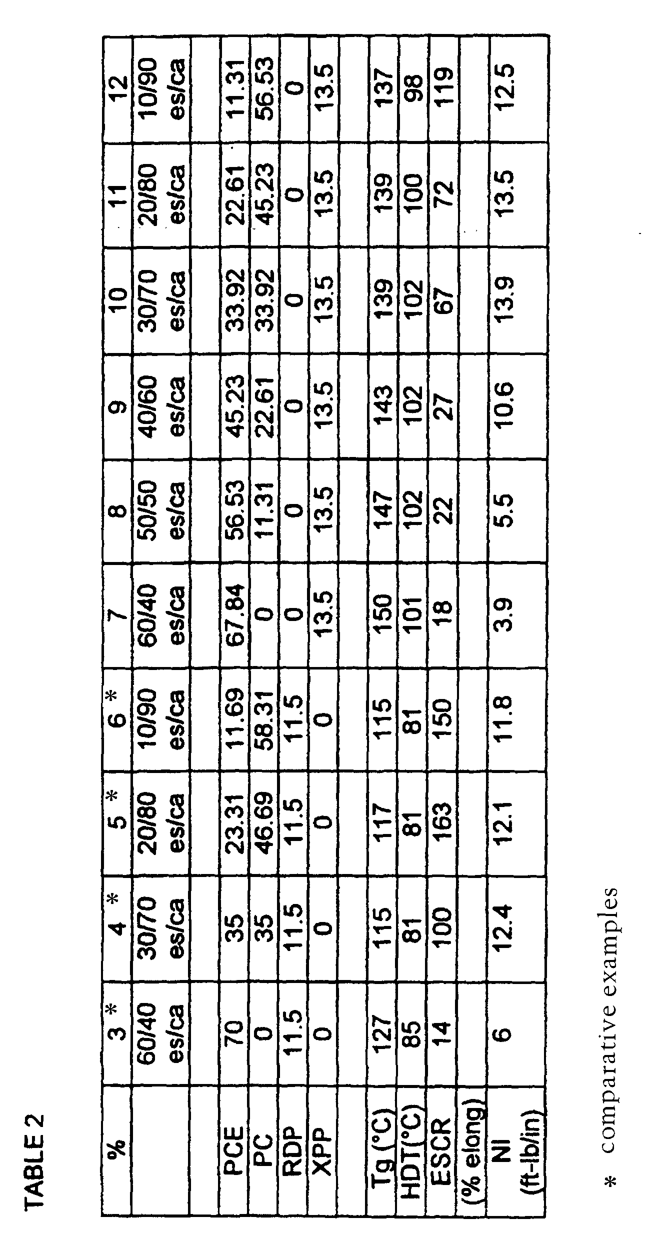

Comparison of Examples 3 to 6 (Table 2) with Example 1 (Table 1) shows that using different levels of polyestercarbonate copolymers (different ester / carbonate ratios) results in an increase in the polycarbonate phase Tg of 11 to 23°C. In addition, combinations of these PCE copolymers with the less plasticizing phosphoramide (XPP), (Examples 7 to 12, Table 2), lead to compositions with an increase in the polycarbonate phase Tg of 33 to 46°C.

The data also show that using PCE copolymers has a positive effect on the impact properties of the resulting blends. The notched Izod impact strength at room temperature increases significantly from 6 ft-lb/in to 12 ft-lb/in for the formulations containing RDP (Examples 3-6), and from 4 ft-lb/in to 14 ft-lb/in for the formulations containing XPP (Examples 7-12).

A similar effect is also observed for % tensile elongation after exposure to solvent (ESCR). Initially, Examples 3, 7, 8 and 9 in Table 2 show that the ESCR performance of PCE containing blends (60 to 40 wt% ester) does not meet the requirements for typical applications (cf. Example 1, Table 1). However, Examples 4, 5, and 6 and Examples 10, 11, and 12 show very clearly that at a certain weight ratio of ester / carbonate (30 wt.% ester and lower), flame retardant compositions can be achieved with an excellent combination of ESCR, ductility and high heat performance.

## Claims

1. A resin composition comprising the following and any reaction products thereof:
a) at least one polyestercarbonate comprising structural units of the formula I: 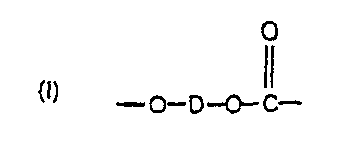 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 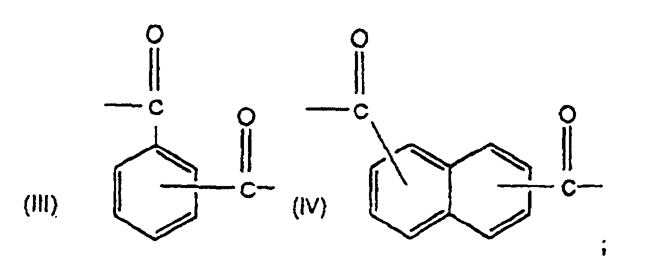
b) at least one addition polymer; and
c) at least one phosphoramide compound having a glass transition point of at least 0°C of the formula V: 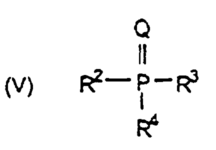 wherein Q is oxygen; and R² is an amine residue and, R³ and R⁴ are each independently an alkyloxy, alkylthio, aryloxy, or arylthio residue, or an aryloxy or arylthio residue containing at least one alkyl or halogen substitution, or mixture thereof; or an amine residue.

2. The composition according to claim 1 wherein D comprises units derived from bisphenol A.

3. The composition according to claim 1 wherein D comprises units derived from 6,6'-dihydroxy-3,3,3',3'-tetramethyl-1,1'-spirobiindane.

4. The composition according to claim 1 wherein R¹ comprises units derived from at least one of isophthalic acid, terephthalic acid, and naphthalene-2,6-dicarboxylic acid.

5. The composition according to claim 1 wherein R¹ comprises units derived from a mixture of isophthalic acid and terephthalic acid.

6. The composition according to claim 5 wherein the weight ratio of isophthalic acid to terephthalic add is in the range of 95:5 to 5:95.

7. The composition according to claim 6 wherein the weight ratio of isophthalic acid to terephthalic acid is in the range of 93:7 to 50:50.

8. The composition according to claim 1 wherein the weight ratio of formula I units to formula II units is in the range of 10: 90 to 90:10.

9. The composition according to claim 8 wherein the weight ratio of formula I units to formula II units is in the range of 20:80 to 40:60.

10. The composition according to claim 1 wherein the addition polymer is a copolymer of an alkenylaromatic compound.

11. The composition according to claim 10 wherein the alkenylaromatic compound is styrene.

12. The composition according to claim 11 wherein the addition polymer is at least one styrene-acrylonitrile copolymer.

13. The composition according to claim 12 wherein the addition polymer is a combination of two styrene-acrylonitrile copolymers.

14. The composition according to claim 13 wherein one of the styrene-acrylonitrile copolymers is an ABS copolymer.

15. The composition according to claim 1 which comprises 55-95% by weight polyestercarbonate portion and 5-45% by weight addition polymer, based on total resinous constituents.

16. The composition according to claim 1 wherein the phosphoramide compound is a phosphoramide of the formula XII: 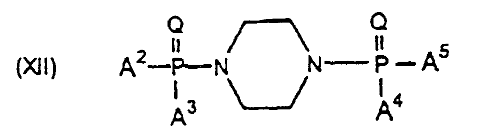 wherein each Q is oxygen; and each of A²⁻⁵ is a 2,6-dimethylphenoxy moiety or a 2,4,6-trimethylphenoxy moiety.

17. The composition of claim 16 wherein the phosphoramide compound is a phosphoramide of the formula XII: 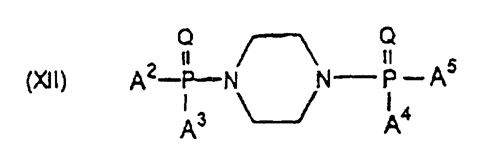 wherein each Q is oxygen; and each of A²⁻⁵ is a 2,6-dimethylphenoxy moiety.

18. The composition of claim 1 wherein all of the phosphoramide has a glass transition point of at least 0°C.

19. The composition of claim 1 wherein R² is of the formula XVI: 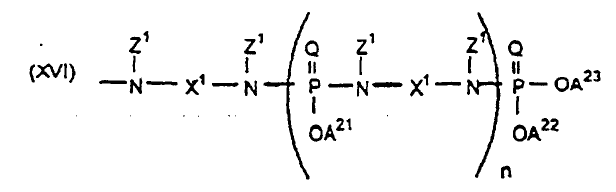 wherein
each Q is independently oxygen or sulfur;
each of A²¹⁻²³ is independently an alkyloxy, alkylthio, aryloxy, or arylthio residue, or an aryloxy or arylthio residue containing at least one alkyl substitution; or an amine residue;
each Z¹ is an alkyl radical, aromatic radical, or aromatic radical containing at least one alkyl substitution;
each X¹ is an alkylidene radical, aromatic radical, or aromatic radical containing at least one alkyl substitution;
n is from 0 to 5; and
R³ and R⁴ are each independently an alkyloxy, alkylthio, aryloxy, or arylthio residue, or an aryloxy or arylthio residue containing at least one alkyl substitution; or an amine residue.

20. The composition of claim 1 wherein R² is of the formula XI: 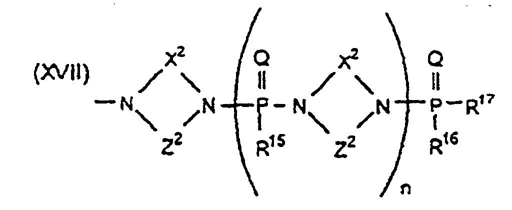 wherein
each Q is independently oxygen or sulfur;
each X² is alkylidene, aryl, or alkaryl;
each Z² is alkylidene;
each of R¹⁵, R¹⁶, and R¹⁷ is independently an alkyloxy residue, an aryloxy residue, an aryloxy residue containing at least one alkyl substitution, or an amine residue; and
n is from 0 to 5; and
R³ and R⁴ are each independently an alkyloxy, alkylthio, aryloxy, or arylthio residue, or an aryloxy or arylthio residue containing at least one alkyl substitution; or an amine residue.

21. The composition of claim 1 wherein at least one phosphoramide compound is present in an amount effective to render the resin composition a flame rating of V-0, V-1, or V-2 in the Underwriter's Laboratory UL-94 protocol when measured on a test specimen of 3.2 mm (0.125 inch) by 12.7 mm (0.5 inch) by 127 mm (5 inch) dimensions.

22. The composition of claim 1 wherein the total amount of phosphorus per 100 parts of resinous materials is in the range of 0.1-3 parts by weight.

23. The composition of claim 1 which is essentially free of chlorine and bromine.

24. A resin composition comprising the following and any reaction products thereof:
a) at least one polyestercarbonate comprising structural units of the formula I: 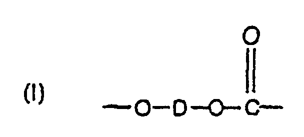 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 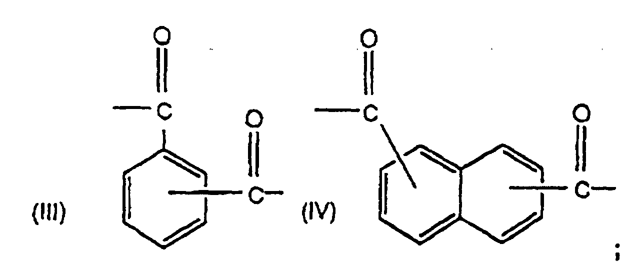
b) at least one addition polymer; and
c) at least one phosphoramide having a glass transition point of at least 0°C of the formula XIV: 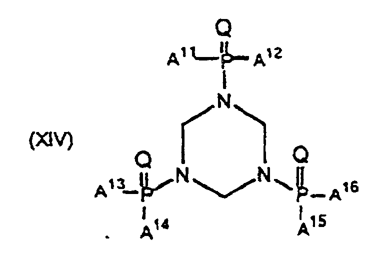 wherein
each Q is independently oxygen; and
each of A¹¹⁻¹⁶ is independently an alkyloxy, alkylthio, aryloxy, or arylthio residue, or an aryloxy or arylthio residue containing at least one alkyl substitution; or an amine residue.

25. A resin composition comprising the following and any reaction products thereof:
a) at least one polyestercarbonate comprising structural units of the formula I: 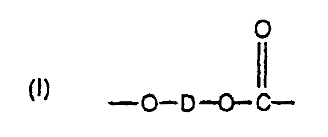 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 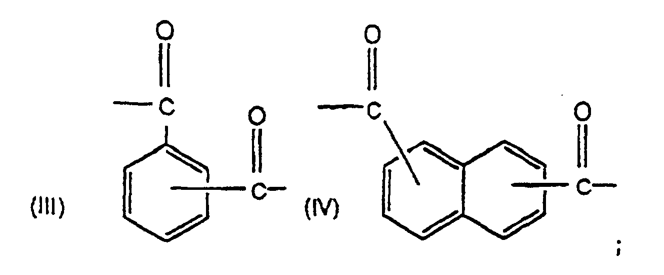
b) at least one addition polymer; and
c) at least one cyclic phosphoramide having a glass transition point of at least 0°C of the formula XVIII: 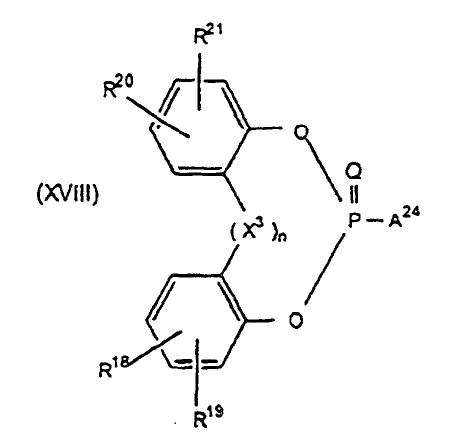 wherein Q is oxygen or sulfur; each R¹⁸⁻²¹ is independently a hydrogen or an alkyl radical; X³ is a alkylidene radical; n is 0 or 1; and A²⁴ is a group derived from a primary or secondary amine that can be aliphatic, alicyclic, aromatic, or alkaryl, or A²⁴ is a group derived from a heterocyclic amine, or A²⁴ is a hydrazine compound.

26. A resin composition comprising the following and any reaction products thereof:
a) at least one polyestercarbonate comprising structural units of the formula I: 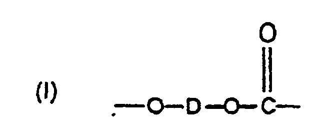 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 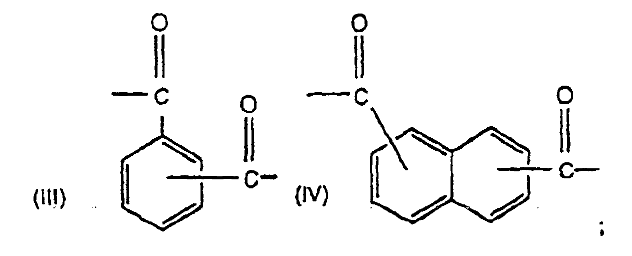
b) at least one addition polymer; and
c) at least one cyclic phosphoramide having a glass transition point of at least 0°C of the formula XIX: 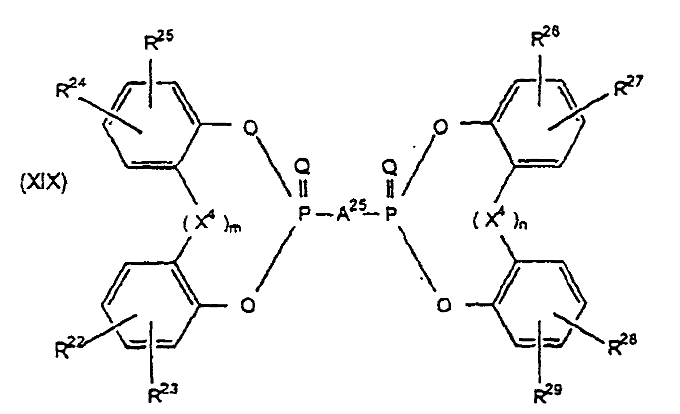
wherein each Q is oxygen; each of R²²⁻²⁹ is independently a hydrogen or an alkyl radical; and A²⁵ is 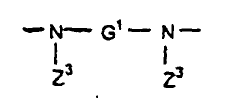 wherein G¹ is sulfur, an alkyl, aryl, or alkaryl radical, X⁴ is an alkylidene radical, each of m and n is independently 0 or 1, and each Z³ is independently an alkyl radical or an aryl radical, or
wherein A²⁵ is 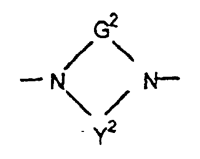 wherein G² is alkyl, aryl, or alkaryl, and Y² is alkyl.

27. An article made from the composition of claim 1.

28. The article of claim 27 which is a deflection yoke for cathode ray tube, deflection yoke for television, slit type deflection yoke, mold coil deflection yoke, television backplate, docking station, pedestal, bezel, pallet, switch, switch housing, plug, plug housing, electrical connector, connecting device, socket, television housing, computer housing, desk-top computer housing, portable computer housing, lap-top computer housing, palm-held computer housing; monitor housing, printer housing, keyboard, FAX machine housing, copier housing, telephone housing, mobile phone housing, radio sender housing, radio receiver housing, light fixture, battery charger housing, battery housing, automotive electrical component, antenna housing, transformer housing, modem, cartridge, network interface device housing, circuit breaker housing, meter housing, panel for wet or dry appliance, dishwasher panel, clothes washer panel, clothes dryer panel, refrigerator panel; heating or ventilation enclosure, fan, air conditioner housing, cladding or seating for public transportation; or cladding or seating for trains, subways, or buses.

29. A method to increase the heat distortion temperature of a flame resistant composition containing an amount of a phosphoryl compound effective to render the composition a flame rating of at least V-2 in the Underwriter's Laboratory UL-94 protocol when measured on a test specimen of 3.2 mm (0.125 inch)by 12.7 mm (0.5 inch) by 127 mm (5 inch) dimensions, wherein the method comprises combining
a) at least one polyestercarbonate comprising structural units of the formula I: 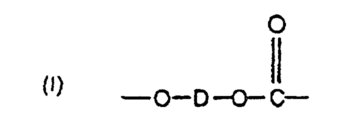 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 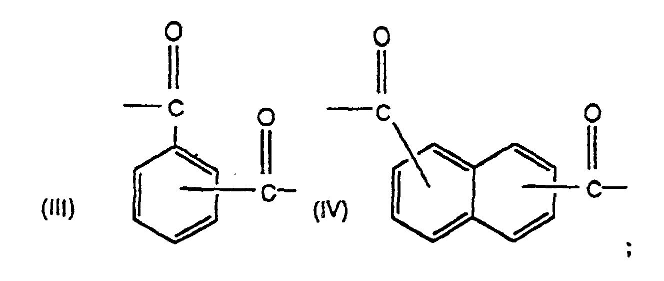
b) at least one addition polymer; and
c) at least one phosphoramide compound having a glass transition point of at least 0°C of the formula V: 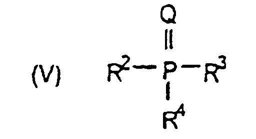 wherein Q is oxygen; and R² is an amine residue, and, R³, and R⁴ are each independently an alkyloxy, alkylthio, aryloxy, or arylthio residue, or an aryloxy or arylthio residue containing at least one alkyl or halogen substitution, or mixture thereof; or an amine residue.

30. The method according to claim 29 wherein D comprises units derived from bisphenol A.

31. The method according to claim 29 wherein D comprises units derived from 6,6'-dihydroxy-3,3,3',3'-tetramethyl-1,1'-spirobiindane.

32. The method according to claim 29 wherein R¹ comprises units derived from at least one of isophthalic acid, terephthalic acid, and naphthalene-2,6-dicarboxylic acid.

33. The method according to claim 29 wherein R¹ comprises units derived from a mixture of isophthalic acid and terephthalic acid.

34. The method according to claim 33 wherein the weight ratio of isophthalic acid to terephthalic acid is in the range of 95:5 to 5:95.

35. The method according to claim 34 wherein the weight ratio of isophthalic acid to terephthalic acid is in the range of 93:7 to 50:50.

36. The method according to claim 29 wherein the weight ratio of formula I units to formula II units is in the range of 10: 90 to 90:10.

37. The method according to claim 36 wherein the weight ratio of formula I units to formula II units is in the range of 20: 80 to 40:60.

38. The method according to claim 29 wherein the addition polymer is a copolymer of an alkenylaromatic compound.

39. The method according to claim 38 wherein the alkenylaromatic compound is styrene.

40. The method according to claim 39 wherein the addition polymer is at least one styrene-acrylonitrile copolymer.

41. The method according to claim 40 wherein the addition polymer is a combination of two styrene-acrylonitrile copolymers.

42. The method according to claim 41 wherein one of the styrene-acrylonitrile copolymers is an ABS copolymer.

43. The method according to claim 29 which comprises 55-95% by weight polyestercarbonate portion and 5-45% by weight addition polymer, based on total resinous constituents.

44. The method according to claim 29 wherein the phosphoramide compound is a phosphoramide of the formula XII: 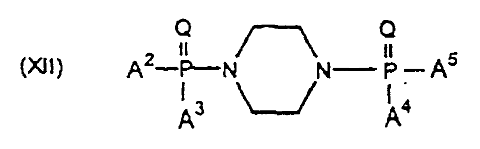 wherein each Q is independently oxygen; and each of A²⁻⁵ is a 2,6-dimethylphenoxy moiety or a 2,4,6-trimethylphenoxy moiety.

45. The method of claim 44 wherein the phosphoramide compound is a phosphoramide of the formula VI: 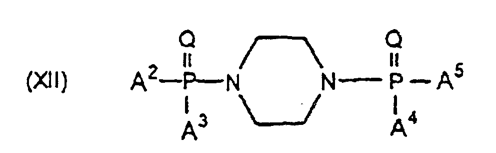 wherein Q is oxygen; and each of A²⁻⁵ is a 2,6-dimethylphenoxy moiety.

46. The method of claim 29 wherein all of the phosphoramide has a glass transition point of at least 0°C.

47. The method of claim 29 wherein R² is of the formula XVI: 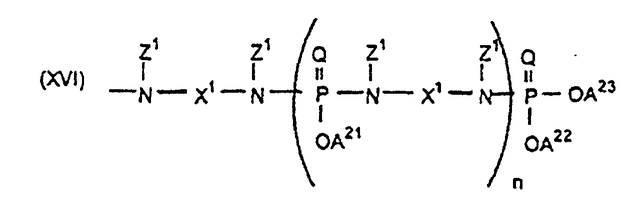 wherein
each Q is independently oxygen or ;
each of A²¹⁻²³ is independently an alkyloxy, alkylthio, aryloxy, or arylthio residue, or an aryloxy or arylthio residue containing at least one alkyl substitution; or an amine residue;
each Z¹ is an alkyl radical, aromatic radical, or aromatic radical containing at least one alkyl substitution;
each X¹ is an alkylidene radical, aromatic radical, or aromatic radical containing at least one alkyl substitution;
n is from 0 to 5; and
R³ and R⁴ are each independently an alkyloxy, alkylthio, aryloxy, or arylthio residue, or an aryloxy or arylthio residue containing at least one alkyl substitution; or an amine residue.

48. The method of claim 29 wherein R² is of the formula XI: 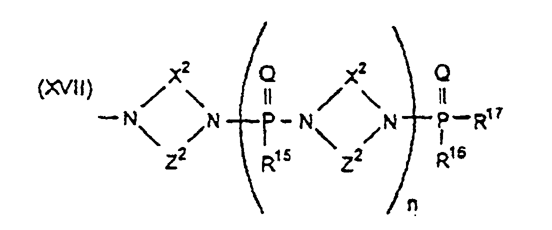 wherein
each Q is independently oxygen;
each X² is alkylidene, aryl, or alkaryl;
each Z² is alkylidene;
each of R¹⁵, R¹⁶, and R¹⁷ is independently an alkyloxy residue, an aryloxy residue, an aryloxy residue containing at least one alkyl substitution, or an amine residue; and
n is from 0 to 5; and
R³ and R⁴ are each independently an alkyloxy, alkylthio, aryloxy, or arylthio residue, or an aryloxy or arylthio residue containing at least one alkyl substitution; or an amine residue.

49. The method of claim 29 wherein at least one phosphoramide compound is present in an amount effective to render the resin composition a flame rating of V-0, V-1, or V-2 in the Underwriter's Laboratory UL-94 protocol when measured on a test specimen of about 3.2 mm (0.125 inch) by 12.7 mm (0.5 inch) by 127 mm (5 inch) dimensions.

50. The method of claim 29 wherein the total amount of phosphorus per 100 parts of resinous materials is in the range of 0.1-3 parts by weight.

51. The method of claim 29 wherein the composition has a flame rating of least V-1.

52. The method of claim 29 wherein the composition has a flame rating of least V-0.

53. The method of claim 29 in which the composition is essentially free of chlorine and bromine.

54. The flame resistant composition of claim 53.

55. The flame resistant composition of claim 29.

56. A resin composition comprising the following and any reaction products thereof:
a) at least one polyestercarbonate comprising structural units of the formula I: 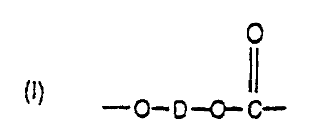 wherein D is a divalent aromatic radical; and repeating or recurring structural units of the formula II:
(II) ―O―R'―O―D―
wherein D has the meaning previously ascribed to it and R¹ is at least one 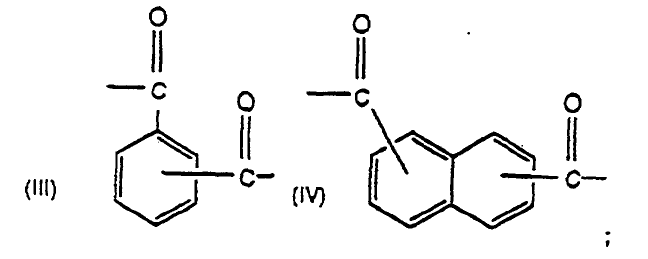
b) at least one addition polymer; and
c) a phosphoramide having a glass transition point of at least 20°C of the formula XII: 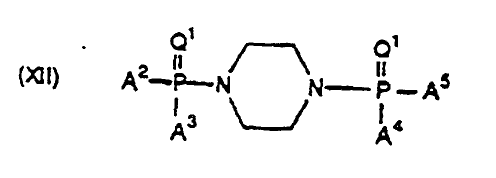 wherein each Q¹ is oxygen; and each A moiety is a 2,6-dimethylphenoxy moiety.

57. The composition according to claim 56 wherein D comprises units derived from bisphenol A.

58. The composition according to claim 56 wherein R¹ comprises units derived from at least one of isophthalic acid, terephthalic acid, and naphthalene 2,6-dicarboxylic acid.

59. The composition according to claim 56 wherein the addition polymer is a copolymer of an alkenylaromatic compound.

60. The composition according to claim 59 wherein the alkenylaromatic compound is styrene.

61. The composition according to claim 60 wherein the addition polymer is at least one styrene-acrylonitrile copolymer.

62. The composition according to claim 61 wherein the addition polymer is a combination of two styrene-acrylonitrile copolymers.

63. The composition according to claim 62 wherein one of the styrene-acrylonitrile copolymers is an ABS copolymer.

64. A method to increase the heat distortion temperature of a flame resistant composition containing an amount of a phosphoramide compound effective to render the composition a flame rating of at least V-2 in the Underwriter's Laboratory UL-94 protocol when measured on a test specimen of 3.2 mm (0.125 inch) by 12.7 mm (0.5 inch) by 127 mm (5 inch) dimensions, wherein the method comprises combining
a) at least one polyestercarbonate comprising structural 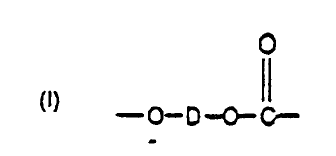 wherein D is a divalent aromatic radical; and repeating or recurring structural units of the formula II:
(II) ―O―R¹―O―D―
wherein D has the meaning previously ascribed to it and R¹ is at least one divalent moiety selected from those of the formulae III and IV: 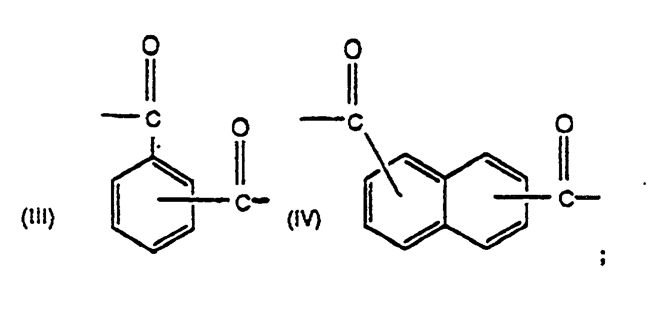
b) at least one addition polymer, and
c) a phosphoramide having a glass transition point of at least 20°C of the formula Xll: 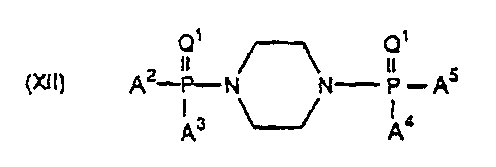 wherein each Q¹ is oxygen; and each A moiety is a 2,6-dimethylphenoxy moiety.

65. The composition according to claim 64 wherein D-comprises units derived from bisphenol A.

66. The composition according to claim 64 wherein R¹ comprises units derived from at least one of isophthalic acid, terephthalic acid, and naphthalene-2,6-dicarboxylic acid.

67. The composition according to claim 64 wherein the addition polymer is a copolymer of an alkenylaromatic compound.

68. The composition according to claim 67 wherein the alkenylaromatic compound is styrene.

69. The composition according to claim 68 wherein the addition polymer is at least one styrene-acrylonitrile copolymer

70. The composition according to claim 70 wherein the addition polymer is a combination of two styrene-acrylonitrile copolymers.

71. The composition according to claim 70 wherein one of the styrene-acrylonitrile copolymers is an ABS copolymer.

## Patentansprüche

1. Harzzusammensetzung, umfassend die Folgenden und irgendwelche Reaktionsprodukte davon:
a) mindestens ein Polyestercarbonat, umfassend Struktureinheiten der Formel I: 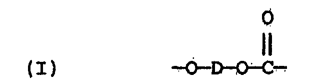 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 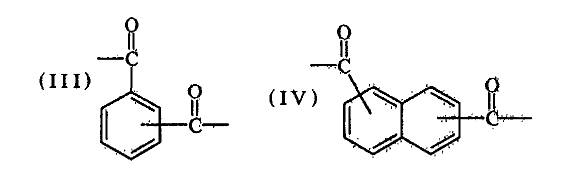
b) mindestens ein Anlagerungspolymer und
c) mindestens eine Phosphoramid-Verbindung mit einem Glasübergangspunkt von mindestens 0°C und der Formel V: 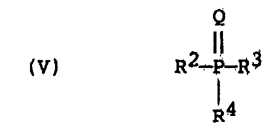 worin Q Sauerstoff ist, R² ein Aminrest ist, und R³ und R⁴ jeweils unabhängig ein Alkyloxy-, Alkylthio-, Aryloxy- oder Arylthiorest oder ein Aryloxy- oder Arylthiorest, der mindestens eine Alkyl- oder Halogen-Substitution enthält oder eine Mischung davon öder ein Aminrest ist.

2. Zusammensetzung nach Anspruch 1, worin D Einheiten umfasst, die von Bisphenol A abgeleitet sind.

3. Zusammensetzung nach Anspruch 1, worin D Einheiten umfasst, die von 6,6'-Dihydroxy-3,3,3',3'-tetramethyl-1,1'-spirobiindan abgeleitet sind.

4. Zusammensetzung nach Anspruch 1, worin R¹ Einheiten umfasst, die von mindestens einer von Isophthalsäure, Terephthalsäure und Naphthalin-2,6-dicarbonsäure abgeleitet sind.

5. Zusammensetzung nach Anspruch 1, worin R¹ Einheiten umfasst, die von einer Mischung aus Isophthalsäure und Terephthalsäure abgeleitet sind.

6. Zusammensetzung nach Anspruch 2, worin das Gewichtsverhältnis von Isophthalsäure zu Terephthalsäure im Bereich von 95:5 bis 5:95 liegt.

7. Zusammensetzung nach Anspruch 6, worin das Gewichtsverhältnis von Isophthalsäure zu Terephthalsäure im Bereich von 93:7 bis 50:50 liegt.

8. Zusammensetzung nach Anspruch 1, worin das Gewichtsverhältnis der Einheiten der Formel I zu den Einheiten der Formel II im Bereich von 10:90 bis 90:10 liegt.

9. Zusammensetzung nach Anspruch 8, worin das Gewichtsverhältnis der Einheiten der Formel I zu den Einheiten der Formel II im Bereich von 20:80 bis 40:60 liegt.

10. Zusammensetzung nach Anspruch 1, worin das Anlagerungspolymer ein Copolymer einer aromatischen Alkenylverbindung ist.

11. Zusammensetzung nach Anspruch 10, worin die aromatische Alkenylverbindung Styrol ist.

12. Zusammensetzung nach Anspruch 11, worin das Anlagerungspolymer mindestens ein Styrol-Acrylnitril-Copolymer ist.

13. Zusammensetzung nach Anspruch 12, worin das Anlagerungspolymer eine Kombination von zwei Styrol-Acrylnitril-Copolymeren ist.

14. Zusammensetzung nach Anspruch 13, worin eines der Styrol-Acrylnitril-Copolymeren ein ABS-Copolymer ist.

15. Zusammensetzung nach Anspruch 1, umfassend 55-95 Gew.-% Polyestercarbonat-Anteil und 5-45 Gew.-% Anlagerungspolymer, bezogen auf die gesamten Harzbestandteile.

16. Zusammensetzung nach Anspruch 1, worin die Phosphoramid-Verbindung ein Phosphoramid der Formel XII ist: 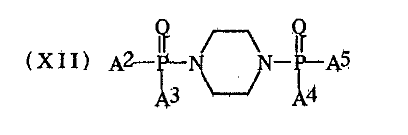 worin jedes Q Sauerstoff ist und jedes von A²⁻⁵ eine 2,6-Dimethylphenoxy-Gruppierung oder eine 2,4,6-Trimethylphenoxy-Gruppierung ist.

17. Zusammensetzung nach Anspruch 16, worin die Phosphoramid-Verbindung ein Phosphoramid der Formel XII ist: 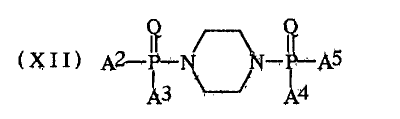 worin jedes Q Sauerstoff ist und jedes von A²⁻⁵ eine 2,6-Dimethylphenoxy-Gruppierung ist.

18. Zusammensetzung nach Anspruch 1, worin das gesamte Phosphoramid einen Glasübergangspunkt von mindestens 0°C hat.

19. Zusammensetzung nach Anspruch 1, worin R² die Formel XVI hat: 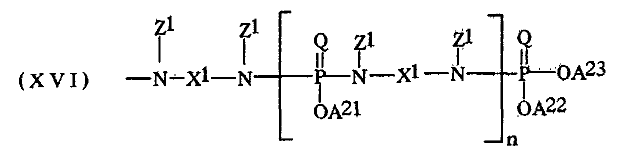 worin jedes Q unabhängig Sauerstoff oder Schwefel ist,
jedes von A²¹⁻²³ unabhängig ein Alkyloxy-, Alkylthio-, Aryloxy- oder Arylthiorest oder ein Aryloxy- oder Arylthiorest, der mindestens eine Alkylsubstitution enthält oder ein Aminrest ist,
jedes Z¹ ein Alkylrest, atomatischer Rest oder aromatischer Rest ist, der mindestens eine Alkylsubstitution enthält,
jedes X¹ ein Alkylidenrest, aromatischer Rest oder aromatischer Rest ist, der mindestens eine Alkylsubstitution enthält,
n von 0 bis 5 ist und
R³ und R⁴ jeweils unabhängig ein Alkyloxy-, Alkylthio-, Aryloxy- oder Arylthiorest oder ein Aryloxy- oder Arylthiorest, der mindestens eine Alkylsubstitution enthält oder ein Aminrest ist.

20. Zusammensetzung nach Anspruch 1, worin R² die Formel XVII hat: 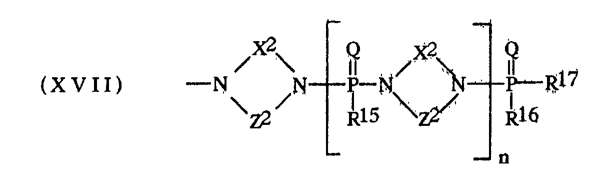 worin jedes Q unabhängig Sauerstoff oder Schwefel ist,
jedes X² Alkyliden, Aryl oder Alkaryl ist,
jedes Z² Alkyliden ist,
jedes von R¹⁵, R¹⁶ und R¹⁷ unabhängig ein Alkyloxyrest, ein Aryloxyrest, ein Aryloxyrest, der mindestens eine Alkylsubstitution enthält, oder ein Aminrest ist und
n von 0 bis 5 ist und
R³ und R⁴ jeweils unabhängig ein Alkyloxy-, Alkylthio-, Aryloxy- oder Arylthiorest oder ein Aryloxy- oder Arylthiorest, der mindestens eine Alkylsubstitution enthält, oder ein Aminrest ist.

21. Zusammensetzung nach Anspruch 1, worin mindestens eine Phosphoramid-Verbindung in einer wirksamen Menge vorhanden ist, um der Harzzusammensetzung eine Entflammungs-Beurteilung von V-0, V-1 oder V-2 im Underwriter's Laboratory UL-94-Protokoll zu geben, wenn an einer Testprobe mit Abmessungen von 3,2 mm (0,125 inch) x 12,7 mm (0,5 inch) x 127 mm (5 inch) gemessen.

22. Zusammensetzung nach Anspruch 1, worin die Gesamtmenge des Phosphors auf 100 Teile harzartiger Materialien im Bereich von 0,1-3 Gewichtsteilen liegt.

23. Zusammensetzung nach Anspruch 1, die im Wesentlichen frei von Chlor und Brom ist.

24. Harzzusammensetzung, umfassend die Folgenden und irgendwelche Reaktionsprodukte davon:
a) mindestens ein Polyestercarbonat, umfassend Struktureinheiten der Formel I: 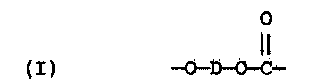 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 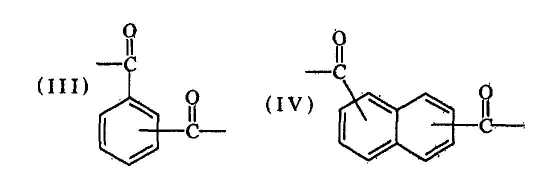
b) mindestens ein Anlagerungspolymer und
c) mindestens ein Phosphoramid mit einem Glasübergangspunkt von mindestens 0°C und der Formel XIV: 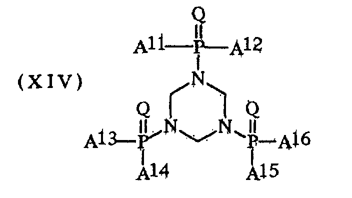 worin jedes Q unabhängig Sauerstoff ist und
jedes von A¹¹⁻¹⁶ unabhängig ein Alkyloxy-, Alkylthio-, Aryloxy- oder Arylthiorest oder ein Aryloxy- oder Arylthiorest, der mindestens eine Alkylsubstitution enthält, oder ein Aminrest ist.

25. Harzzusammensetzung, umfassend die Folgenden und irgendwelche Reaktionsprodukte davon;
a) mindestens ein Polyestercarbonat, umfassend Struktureinheiten der Formel I: 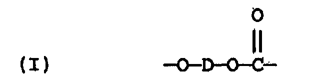 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 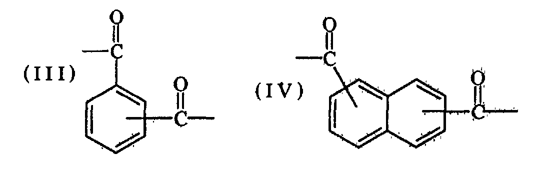
b) mindestens ein Anlagerungspolymer und
c) mindestens ein cyclisches Phosphoramid mit einem Glasübergangspunkt von mindestens 0°C und der Formel XVIII 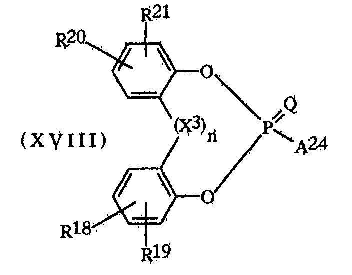 worin jedes Q Sauerstoff oder Schwefel ist, jedes R¹⁸⁻²¹ unabhängig ein Wasserstoff oder ein Alkylrest ist, X³ ein Alkylidenrest ist, n 0 oder 1 ist und A²⁴ eine von einem primären oder sekundären Amin abgeleitete Gruppe ist, die aliphatisch, alicyclisch, aromatisch oder Alkaryl sein kann, oder A²⁴ eine von einem heterocyclischen Amin abgeleitete Gruppe ist oder A²⁴ eine Hydrazin-Verbindung ist.

26. Harzzusammensetzung, umfassend die Folgenden und irgendwelche Reaktionsprodukte davon:
a) mindestens ein Polyestercarbonat, umfassend Struktureinheiten der Formel I: 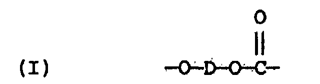 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 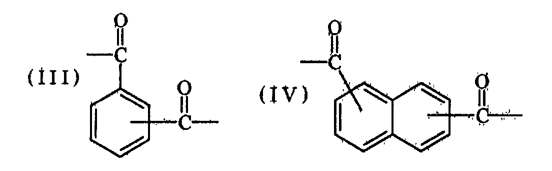
b) mindestens ein Anlagerungspolymer und
c) mindestens ein cyclisches Phosphoramid mit einem Glasübergangspunkt von mindestens 0°C und der Formel XIX : 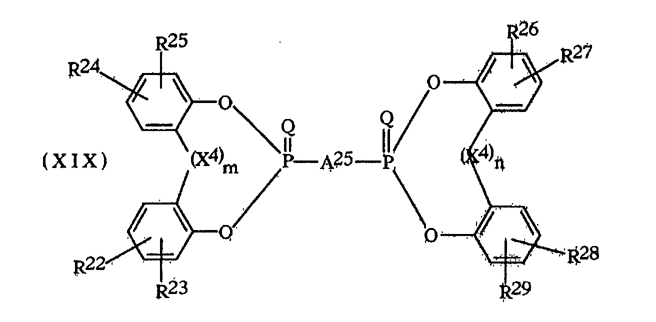 worin jedes Q Sauerstoff ist, jedes von R²²⁻²⁹ unabhängig ein Wasserstoff oder ein Alkylrest ist und A²⁵ 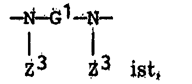 worin G¹ Schwefel, ein Alkyl-, Aryl- oder Alkarylrest ist, X⁴ ein Alkylidenrest ist, jedes von m und n unabhängig 0 oder 1 ist und jedes Z³ unabhängig ein Alkylrest oder ein Arylrest ist oder
worin A²⁵ 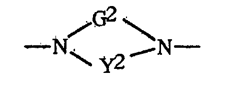 ist, worin G² Alkyl, Aryl oder Alkaryl ist und Y² Alkyl ist.

27. Gegenstand, hergestellt aus der Zusammensetzung nach Anspruch 1.

28. Gegenstand nach Anspruch 27, der ein Ablenkjoch für eine Kathodenstrahlröhre, ein Ablenkjoch für einen Fernseher, Ablenkjoch vom Schlitztyp, Formspulen-Ablenkjoch, Fernseher-Rückplatte, Andockstation, Fußgestell, Beobachtungsfenster, Pallette, Schalter, Schaltergehäuse, Stecker, Steckergehäuse, elektrisches Verbindungsteil, Verbindungsgerät, Sockel, Fernsehgehäuse, Computergehäuse, Desktop-Computergehäuse, Gehäuse eines tragbaren Computers, Gehäuse eines Laptop-Computers, Gehäuse eines Palmheld-Computers, Monitorgehäuse, Druckergehäuse, Tastatur, Gehäuse einer Faxmaschine, Kopierergehäuse, Telefongehäuse, Gehäuse eines Mobiltelefons, Radiosendergehäuse, Radioempfängergehäuse, Beleuchtungsbefestigung, Gehäuse eines Batterieladegerätes, Batteriegehäuse, elektrische Automobilkomponente, Antennengehäuse, Transformatorgehäuse, Modem, Kartusche, Gehäuse für Netzwerkinterface, Gehäuse für Stromkreisunterbrecher, Gehäuse für Meßgerät, Platte für feuchtes oder trockenes Küchengerät, Geschirrwäscherplatte, Waschmaschinenplatte, Kleidertrocknerplatte, Kühlschrankplatte, Heizungs- oder Ventilations-Umhüllung, Ventilator, Gehäuse für Klimaanlage, Hülle oder Sitze für öffentliche Transportmittel oder Hülle oder Sitze für Züge, Untergrundbahnen oder Busse.

29. Verfahren zum Erhöhen der Hitzeverformungs-Temperatur einer entflammungshemmenden Zusammensetzung, die eine Menge einer Phosphorylverbindung enthält, die wirksam ist, der Zusammensetzung eine Entflammungs-Beurteilung von mindestens V-2 im Underwriters Laboratory UL-94-Protokoll zu geben, wenn an einer Testprobe mit Abmessungen von 3,2 mm (0,125 inch) x 12,7 mm (0,5 inch) x 127 mm (5 inch) gemessen wird, wobei das Verfahren das Kombinieren von
a) mindestens einem Polyestercarbonat, umfassend Struktureinheiten der Formel I: 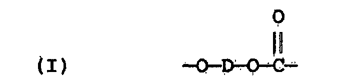 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 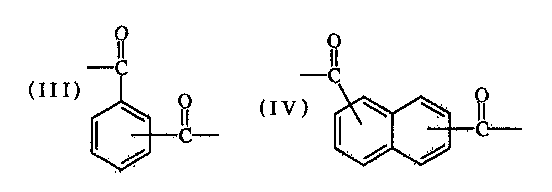
b) mindestens einem Anlagerungspolymer und
c) mindestens einer Phosphoramid-Verbindung mit einem Glasübergangspunkt von mindestens 0°C und der Formel V umfasst: 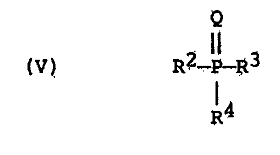 worin Q Sauerstoff ist, R² ein Aminrest ist, und R³ und R⁴ jeweils unabhängig ein Alkyloxy-, Alkylthio-, Aryloxy- oder Arylthiorest oder ein Aryloxy- oder Arylthiorest, der mindestens eine Alkyl- oder Halogen-Substitution enthält oder eine Mischung davon oder ein Aminrest ist, umfasst.

30. Verfahren nach Anspruch 29, worin D Einheiten umfasst, die von Bisphenol A abgeleitet sind.

31. Verfahren nach Anspruch 29, worin D Einheiten umfasst, die von 6,6'-Dihydroxy-3,3,3',3'tetramethyl-1,1'-spirobiindan abgeleitet sind.

32. Verfahren nach Anspruch 29, worin R¹ Einheiten umfasst, die von mindestens einer von Isophthalsäure, Terephthalsäure und Naphthalin-2,6-dicarbonsäure abgeleitet sind.

33. Verfahren nach Anspruch 29, worin R¹ Einheiten umfasst, die von einer Mischung aus Isophthalsäure und Terephthalsäure abgeleitet sind.

34. Verfahren nach Anspruch 33, worin das Gewichtsverhältnis von Isophthalsäure zu Terephthalsäure im Bereich von 95:5 bis 5:95 liegt.

35. Verfahren nach Anspruch 34, worin das Gewichtsverhältnis von Isophthalsäure zu Terephthalsäure im Bereich von 93:7 bis 50:50 liegt.

36. Verfahren nach Anspruch 29, worin das Gewichtsverhältnis der Einheiten der Formel I zu den Einheiten der Formel II im Bereich von 10:90 bis 90:10 liegt.

37. Verfahren nach Anspruch 36, worin das Gewichtsverhältnis der Einheiten der Formel I zu den Einheiten der Formel II im Bereich von 20:80 bis 40:60 liegt.

38. Verfahren nach Anspruch 29, worin das Anlagerungspolymer ein Copolymer einer aromatischen Alkenylverbindung ist.

39. Verfahren nach Anspruch 38, worin die afomatische Alkenylverbindung Styrol ist.

40. Verfahren nach Anspruch 39, worin das Anlagerungspolymer mindestens ein Styrol-Acrylnitril-Copolymer ist.

41. Verfahren nach Anspruch 40, worin das Anlagerungspolymer eine Kombination von zwei Styrol-Acrylnitril-Copolymeren ist,

42. Verfahren nach Anspruch 41, worin eines der Styrol-Acrylnitril-Copolymeren ein ABS-Copolymer ist.

43. Verfahren nach Anspruch 29, umfassend 55-95 Gew.-% Polyestercarbonat-Anteil und 5-45 Gew.-% Anlagerungspolymer, bezogen auf die gesamten Harzbestandteile.

44. Verfahren nach Anspruch 29, worin die Phosphoramid-Verbindung ein Phosphoramid der Formel XII ist: 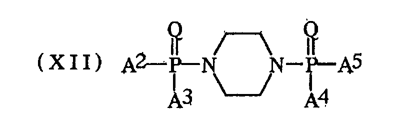 worin jedes Q Sauerstoff ist und jedes von A²⁻⁵ eine 2,6-Dimethylphenoxy-Gruppierung oder eine 2,4,6-Trimethylphenoxy-Gruppierung ist.

45. Verfahren nach Anspruch 44, worin die Phosphoramid-Verbindung ein Phosphoramid der Formel XII ist: 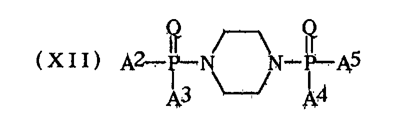 worin jedes Q Sauerstoff ist und jedes von A²⁻⁵ eine 2,6-Dimethylphenoxy-Gruppierung ist.

46. Verfahren nach Anspruch 29, worin das gesamte Phosphoramid einen Glasübergangspunkt von mindestens 0°C hat.

47. Verfahren nach Anspruch 29, worin R² die Formel XVI hat: 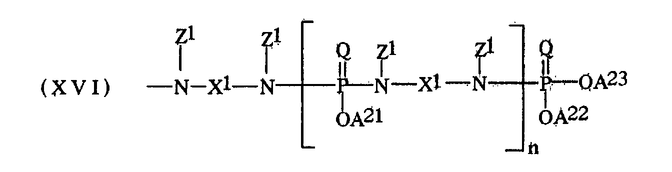 worin jedes Q unabhängig Sauerstoff oder Schwefel ist,
jedes von A²¹⁻²³ unabhängig ein Alkyloxy-, Alkylthio-, Aryloxy- oder Arylthiorest oder ein Aryloxy- oder Arylthiorest, der mindestens eine Alkylsubstitution enthält oder ein Aminrest ist,
jedes Z¹ ein Alkylrest, aromatischer Rest oder aromatischer Rest ist, der mindestens eine Alkylsubstitution enthält,
jedes X¹ ein Alkylidenrest, aromatischer Rest oder aromatischer Rest ist, der mindestens eine Alkylsubstitution enthält,
n von 0 bis 5 ist und
R³ und R⁴ jeweils unabhängig ein Alkyloxy-, Alkylthio-, Aryloxy- oder Arylthiorest oder ein Aryloxy- oder Arylthiorest, der mindestens eine Alkylsubstitution enthält oder ein Aminrest ist,

48. Verfahren nach Anspruch 29, worin R² die Formel XVII hat; 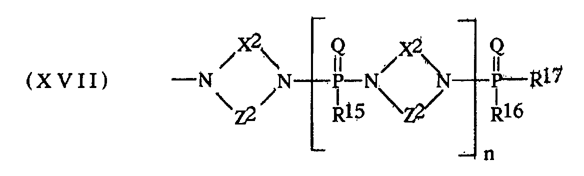 worin jedes Q unabhängig Sauerstoff oder Schwefel ist,
jedes X² Alkyliden, Aryl oder Alkaryl ist,
jedes Z² Alkyliden ist,
jedes von R¹⁵, R¹⁶ und R¹⁷ unabhängig ein Alkyloxyrest, ein Aryloxyrest, ein Aryloxyrest, der mindestens eine Alkylsubstitution enthält, oder ein Aminrest ist und
n von 0 bis 5 ist und
R³ und R⁴ jeweils unabhängig ein Alkyloxy-, Alkylthio-, Aryloxy- oder Arylthiorest oder ein Aryloxy- oder Arylthiorest, der mindestens eine Alkylsubstitution enthält, oder ein Aminrest ist.

49. Verfahren nach Anspruch 29, worin mindestens eine Phosphoramid-Verbindung in einer wirksamen Menge vorhanden ist, um der Harzzusammensetzung eine Entflammungs-Beurteilung von V-0, V-1 oder V-2 im Underwriter's Laboratory UL-94-Protokoll zu geben, wenn an einer Testprobe mit Abmessungen von 3,2 mm (0,125 inch) x 12,7 mm (0,5 inch) x 127 mm (5 inch) gemessen.

50. Verfahren nach Anspruch 29, worin die Gesamtmenge des Phosphors auf 100 Teile harzartiger Materialien im Bereich von 0,1-3 Gewichtsteilen liegt.

51. Verfahren nach Anspruch 29, worin die Zusammensetzung eine Entflammungs-Beurteilung von mindestens V-1 hat.

52. Verfahren nach Anspruch 29, worin die Zusammensetzung eine Entflammungs-Beurteilung von mindestens V-0 hat.

53. Verfahren nach Anspruch 29, die im Wesentlichen frei von Chlor und Brom ist.

54. Entflammungshemmende Zusammensetzung nach Anspruch 53.

55. Entflammungshemmende Zusammensetzung nach Anspruch 29.

56. Harzzusammensetzung, umfassend die Folgenden und irgendwelche Reaktionsprodukte davon:
a) mindestens ein Polyestercarbonat, umfassend Struktureinheiten der Formel I: 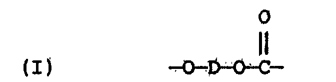 worin D ein zweiwertiger aromatischer Rest ist und
wiederholte oder wiederkehrende Struktureinheiten der Formel II;
(II) ―O―R¹―O―D―
worin D die vorgenannte Bedeutung hat und R¹ mindestens eine zweiwertige Gruppierung ist, ausgewählt aus solchen der Formeln III und IV: 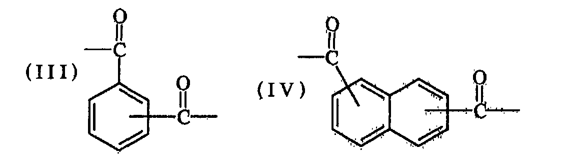
b) mindestens ein Anlagerungspolymer und
c) ein Phosphoramid mit einem Glasübergangspunkt von mindestens 20°C und der Formel XII: 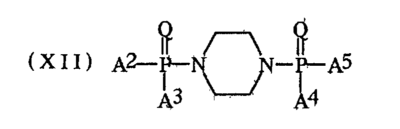 worin jedes Q Sauerstoff und jede A-Gruppierung eine 2,6-Dimethylphenoxy-Gruppierung ist.

57. Zusammensetzung nach Anspruch 56, worin D von Bisphenol A abgeleitete Einheiten umfasst.

58. Zusammensetzung nach Anspruch 56, worin R¹ von mindestens einer von Isophthalsäure, Terephthalsäure und Naphthalin-2,6-dicarbonsäure abgeleitete Einheiten umfasst.

59. Zusammensetzung nach Anspruch 56, worin das Anlagerungspolymer ein Copolymer einer aromatischen Alkenylverbindung ist.

60. Zusammensetzung nach Anspruch 59, worin die aromatische Alkenylverbindung Styrol ist.

61. Zusammensetzung nach Anspruch 60, worin das Anlagerungspolymer mindestens ein Styrol-Acrylnitril-copolymer ist.

62. Zusammensetzung nach Anspruch 61, worin das Anlagerungspolymer eine Kombination von zwei Styrol-Acrylnitril-Copolymeren ist.

63. Zusammensetzung nach Anspruch 62, worin eines der STyrol-Acrylnitril-Copolymeren ein ABS-Copolymer ist.

64. Verfahren zum Erhöhen der Hitzeverformungs-Temperatur einer entflammungshemmenden Zusammensetzung, die eine Menge einer Phosphorylverbindung enthält, die wirksam ist, der Zusammensetzung eine Entflammungs-Beurteilung von mindestens V-2 im Underwriters Laboratory UL-94-Protokoll zu geben, wenn an einer Testprobe mit Abmessungen von 3,2 mm (0,125 inch) x 12,7 mm (0,5 inch) x 127 mm (5 inch) gemessen wird, wobei das Verfahren das Kombinieren von
a) mindestens einem Polyestercarbonat, umfassend Struktureinheiten der Formel I: 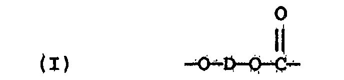 worin D ein zweiwertiger aromatischer Rest ist und
wiederholte oder wiederkehrende Struktureinheiten der Formel II:
(II) ―O―R¹―O―D―
worin D die vorgenannte Bedeutung hat und R¹ mindestens eine zweiwertige Gruppierung ist, ausgewählt aus solchen der Formeln III und IV: 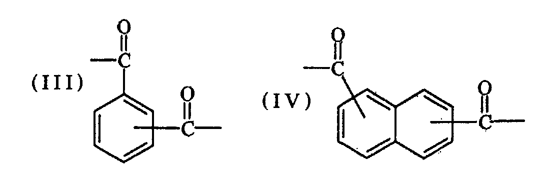
b) mindestens einem Anlagerungspolymer und
c) einem Phosphoramid mit einem Glasübergangspunkt von mindestens 20°C und der Formel XII umfasst: 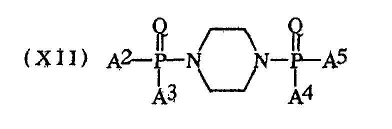 worin jedes Q Sauerstoff und jede A-Gruppierung eine 2,6-Dimethylphenoxy-Gruppierung ist.

65. Verfahren nach Anspruch 64, worin D von Bisphenol A abgeleitete Einheiten umfasst.

66. Verfahren nach Anspruch 64, worin R¹ von mindestens einer von Isophthalsäure, Terephthalsäure und Naphthalin-2,6-dicarbonsäure abgeleitete Einheiten umfasst.

67. Verfahren nach Anspruch 64, worin das Anlagerungspolymer ein Copolymer einer aromatischen Alkenylverbindung ist.

68. Verfahren nach Anspruch 67, worin die aromatische Alkenylverbindung Styrol ist.

69. Verfahren nach Anspruch 68, worin das Anlagerungspolymer mindestens ein Styrol-Acrylnitril-Copolymer ist.

70. Verfahren nach Anspruch 69, worin das Anlagerungspolymer eine Kombination von zwei Styrol-Acrylnitril-Copolymeren ist.

71. Verfahren nach Anspruch 70, worin eines der Styrol-Acrylnitril-Copolymeren ein ABS-Copolymer ist.

## Revendications

1. Composition à base de résine, qui comprend les constituants suivants et tout produit de réaction de ces constituants :
a) au moins un polyestercarbonate comprenant des motifs de formule I : 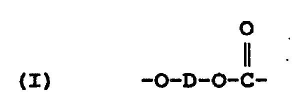 dans laquelle D représente un radical aromatique divalent, et des motifs revenant ou se répétant de formule II :
(II) -O-R¹-O-D-
dans laquelle D a la signification indiquée précédemment et R¹ représente au moins un fragment divalent choisi parmi ceux de formules III et IV : 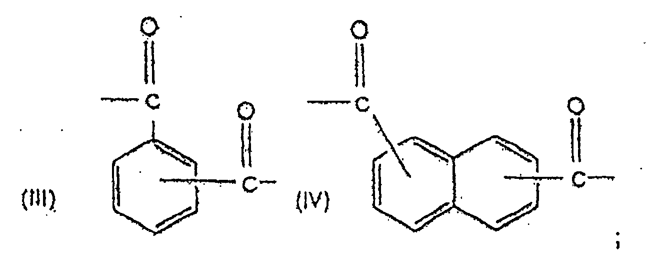
b) au moins un polymère d'addition, et
c) au moins un phosphoramide ayant un point de transition vitreuse d'au moins 0 °C et répondant à la formule V : 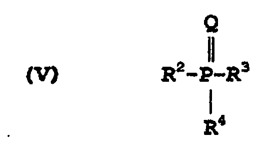 dans laquelle Q représente un atome d'oxygène, R² représente un reste aminé et R³ et R⁴ représentent chacun indépendamment un groupe alcoxy, alkylthio, aryloxy ou arylthio, ou un groupe aryloxy ou arylthio contenant au moins un substituant pris parmi les groupes alkyle et les atomes d'halogène, ou un mélange de ceux-ci, ou encore un reste aminé.

2. Composition selon la revendication 1, dans laquelle D renferme des motifs issus du bisphénol A.

3. Composition selon la revendication 1, dans laquelle D renferme des motifs issus du 6,6'-dihydroxy-3,3,3',3'-tétraméthyl-1,1'-spirobiindane.

4. Composition selon la revendication 1, dans laquelle R¹ renferme des motifs issus d'au moins l'un des composés suivants : acide isophtalique, acide téréphtalique et acide naphtalène-2,6-dicarboxylique.

5. Composition selon la revendication 1, dans laquelle R¹ renferme des motifs issus d'un mélange d'acide isophtalique et d'acide téréphtalique.

6. Composition selon la revendication 5, pour laquelle le rapport en poids de l'acide isophtalique à l'acide téréphtalique est compris dans l'intervalle allant de 95:5 à 5 :95.

7. Composition selon la revendication 6, pour laquelle le rapport en poids de l'acide isophtalique à l'acide téréphtalique est compris dans l'intervalle allant de 93:7 à 50:50.

8. Composition selon la revendication 1, pour laquelle le rapport en poids des motifs de formule I aux motifs de formule II est compris dans l'intervalle allant de 10:90 à 90:10.

9. Composition selon la revendication 8, pour laquelle le rapport en poids des motifs de formule I aux motifs de formule II est compris dans l'intervalle allant de 20:80 à 40:60.

10. Composition selon la revendication 1, dans laquelle le polymère d'addition est un copolymère d'un composé alcénylaromatique.

11. Composition selon la revendication 10, pour laquelle le composé alcénylaromatique est le styrène.

12. Composition selon la revendication 11, dans laquelle le polymère d'addition est au moins un copolymère de styrène et d'acrylonitrile.

13. Composition selon la revendication 12, dans laquelle le polymère d'addition est une combinaison de deux copolymères de styrène et d'acrylonitrile

14. Composition selon la revendication 13, dont l'un des copolymères de styrène et d'acrylonitrile est un copolymère ABS.

15. Composition selon la revendication 1, qui renferme 55 à 95 % en poids de constituant polyester carbonate et 5 à 45 % en poids de polymère d'addition, ces pourcentages étant basés sur les constituants résineux totaux.

16. Composition selon la revendication 1, dont le phosphoramide est un phosphoramide de formule XII : 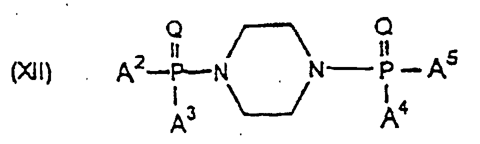 dans laquelle chaque Q représente un atome d'oxygène et chacun de A² à A⁵ représente un groupe 2,6-diméthylphénoxy ou 2,4,6-triméthylphénoxy.

17. Composition selon la revendication 16, dont le phosphoramide est un phosphoramide de formule XII. 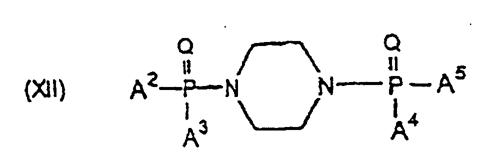 dans laquelle chaque Q représente un atome d'oxygène et chacun de A² à A⁵ représente un groupe 2,6-diméthylphénoxy.

18. Composition selon la revendication 1, dont tous les phosporamides ont un point de transition vitreuse d'au moins 0 °C.

19. Composition selon la revendication 1, pour laquelle R² répond à la formule XVI : 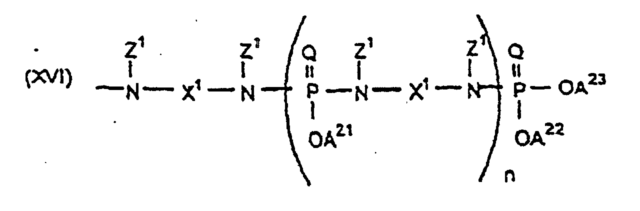 dans laquelle chaque Q représente indépendamment un atome d'oxygène ou de soufre,
chacun de A²¹ à A²³ représente indépendamment un groupe alcoxy, alkylthio, aryloxy ou arylthio, ou un groupe aryloxy ou arylthio portant au moins un groupe alkyle comme substituant, ou encore un reste aminé,
chaque Z¹ représente un groupe alkyle ou aromatique, ou un groupe aromatique portant au moins un groupe alkyle comme substituant,
chaque X¹ représente un groupe alkylidène, un groupe aromatique ou un groupe aromatique portant au moins un groupe alkyle comme substituant, et n désigne un nombre de 0 à 5,
et R³ et R⁴ représentent chacun indépendamment un groupe alcoxy, alkylthio, aryloxy ou arylthio, ou un groupe aryloxy ou arylthio portant au moins un groupe alkyle comme substituant, ou encore un reste aminé.

20. Composition selon la revendication 1, pour laquelle R² répond à la formule XVII : 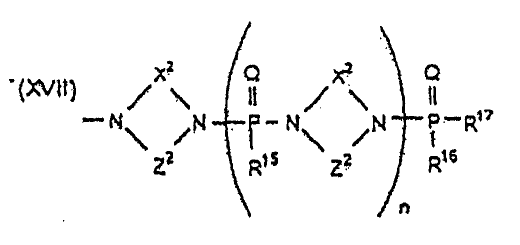 dans laquelle chaque Q représente indépendamment un atome d'oxygène ou de soufre, chaque X² représente un groupe alkylidène, arylène ou alkarylène, chaque Z² représente un groupe alkylidène, chacun de R¹⁵, R¹⁶ et R¹⁷ représente indépendamment un groupe alcoxy, un groupe aryloxy, un groupe aryloxy portant au moins un groupe alkyle comme substituant, ou un reste aminé, et n désigne un nombre de 0 à 5,
et R³ et R⁴ représentent chacun indépendamment un groupe alcoxy, alkylthio, aryloxy ou arylthio, ou un groupe aryloxy ou arylthio portant au moins un groupe alkyle comme substituant, ou encore un reste aminé.

21. Composition selon la revendication 1, dans laquelle au moins un phosphoramide est présent en une proportion permettant d'attribuer à la composition à base de résine un indice d'inflammabilité V-0, V-1 ou V-2, cet indice étant mesuré conformément au protocole UL-94 de Underwriter Laboratory, sur un échantillon pour essai de dimensions 3,2 mm x 12,7 mm x 127 mm (0,125 pouce x 0,5 pouce x 5 pouces).

22. Composition selon la revendication 1, dans laquelle la quantité totale de phosphore est de 0,1 à 3 parties en poids pour 100 parties de matières résineuses.

23. Composition selon la revendication 1, qui est essentiellement exempte de chlore et de brome.

24. Composition à base de résine, qui comprend les constituants suivants et tout produit de réaction de ces constituants :
a) au moins un polyestercarbonate renfermant des motifs de formule I : 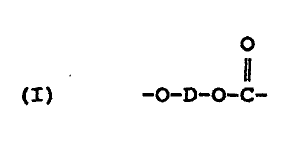 dans laquelle D représente un radical aromatique divalent, et des motifs revenant ou se répétant de formule II :
(II) -O-R¹-O-D-
dans laquelle D a la signification précédemment indiquée et R¹ représente au moins un groupe divalent choisi parmi les groupes de formules III et IV : 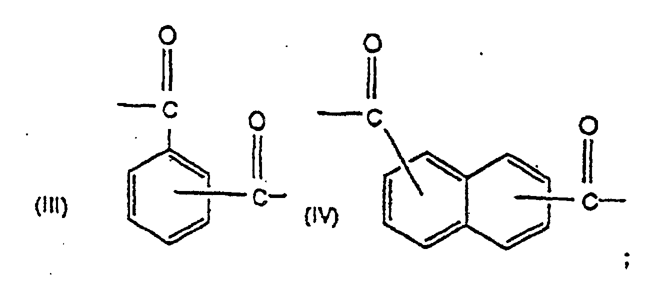
b) au moins un polymère d'addition, et
c) au moins un phosphoramide ayant un point de transition vitreuse d'au moins 0 °C et répondant à la formule XIV : 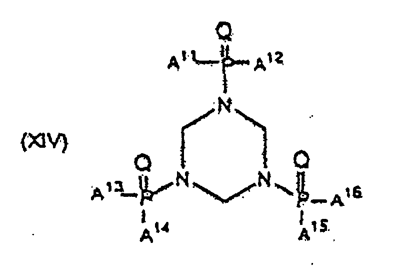 dans laquelle chaque Q représente indépendamment un atome d'oxygène, et chacun de A¹¹ à A¹⁶ représente indépendamment un groupe alcoxy, alkylthio, aryloxy ou arylthio, ou un groupe aryloxy ou arylthio portant au moins un groupe alkyle comme substituant, ou encore un reste aminé.

25. Composition à base de résine, qui comprend les constituants suivants et tout produit de réaction de ces constituants :
a) au moins un polyestercarbonate renfermant des motifs de formule I : 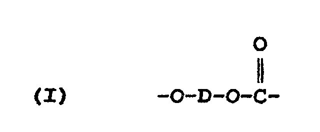 dans laquelle D représente un radical aromatique divalent, et des motifs revenant ou se répétant de formule II :
(II) -O-R¹-O-D-
dans laquelle D a la signification précédemment indiquée et R¹ représente au moins un groupe divalent choisi parmi les groupes de formules III et IV : 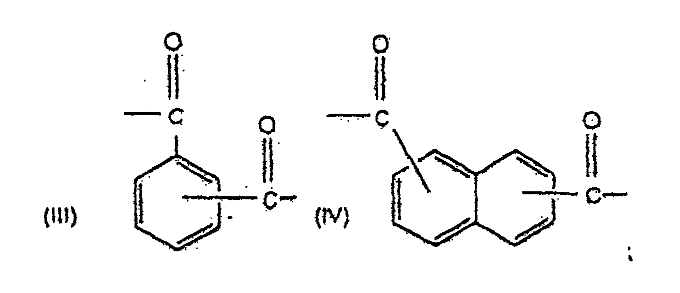
b) au moins un polymère d'addition, et
c) au moins un phosphoramide cyclique ayant un point de transition vitreuse d'au moins 0 °C et répondant à la formule XVIII : 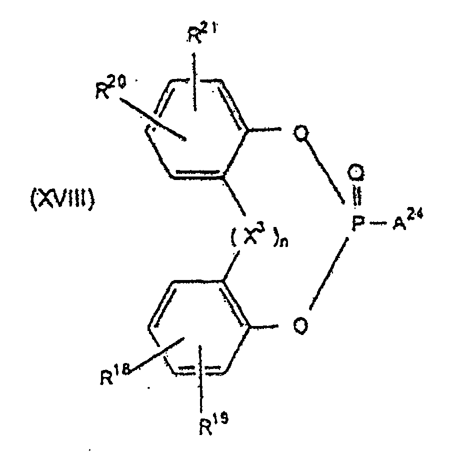 dans laquelle Q représente un atome d'oxygène ou de soufre, chacun de R¹⁸ à R²¹ représente indépendamment un atome d'hydrogène ou un groupe alkyle, X³ représente un groupe alkylidène, n est égal à 0 ou 1, et A²⁴ représente un groupe dérivé d'une aminé primaire ou secondaire qui peut être aliphatique, alicyclique, aromatique ou alkarylique, ou un groupe dérivé d'une amine hétérocyclique, ou un groupe dérivé d'une hydrazine.

26. Composition à base de résine, qui comprend les constituants suivants et tout produit de réaction de ces constituants.
a) au moins un polyestercarbonate renfermant des motifs de formule I : 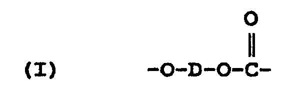 dans laquelle D représente un radical aromatique divalent, et des motifs revenant ou se répétant de formule II :
(II) -O-R¹-O-D-
dans laquelle D a la signification indiquée précédemment et R¹ représente au moins un groupe divalent choisi parmi les groupes de formules III et IV : 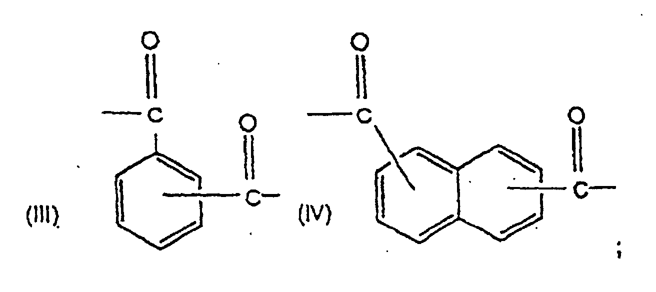
b) au moins un polymère d'addition, et
c) au moins un phosphoramide cyclique ayant un point de transition vitreuse d'au moins 0 °C et répondant à la formule XIX : 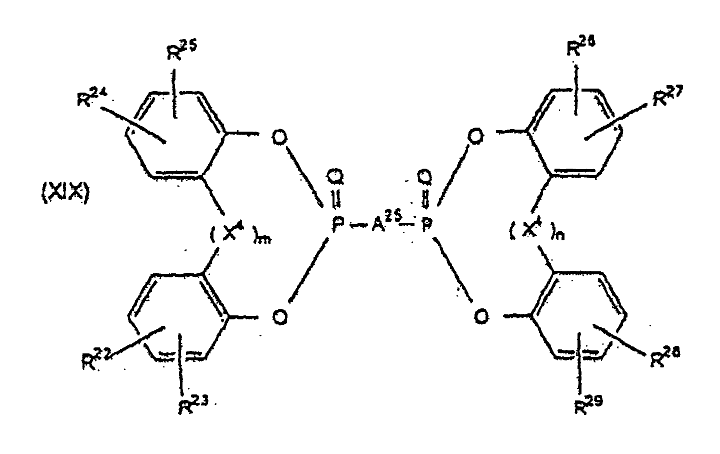 dans laquelle chaque Q représente un atome d'oxygène, chacun de R²² à R²⁹ représente indépendamment un atome d'hydrogène ou un groupe alkyle, X⁴ représente un groupe alkylldène, chacun de m et n représente indépendamment 0 ou 1, et A²⁵ représente 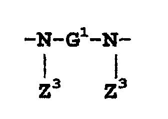 où G¹ désigne un atome de soufre ou un groupe alkylidène, arylène ou alkarylène, et chaque Z³ représente indépendamment un groupe alkyle ou un groupe aryle, ou bien A²⁵ représente 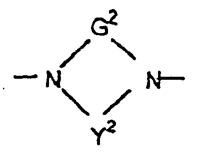 où G² représente un groupe alkylidène, arylène ou alkarylène et Y² représente un groupe alkylidène.

27. Article préparé à partir de la composition selon la revendication 1.

28. Article selon 1a revendication 27, qui est un collier de déviation pour tube à rayons cathodiques, un collier de déviation pour la télévision, un collier de déviation du type fente, un collier de déviation de bobine de moulage, une plaque arrière de télévision, un poste d'accostage, un support, une lunette d'encadrement, une palette, un commutateur, un logement de commutateur, une fiche, un logement de fiche, un connecteur électrique, un dispositif de connexion, une prise femelle, un logement pour la télévision, un logement d'ordinateur, un logement d'ordinateur de bureau, un logement d'ordinateur portable, un logement d'ordinateur portatif, un logement d'ordinateur tenu dans la paume, un logement de moniteur, un logement d'imprimante, un clavier, un logement de télécopieur, un logement de photocopieur, un logement de téléphone, un logement de téléphone mobile, un logement d'émetteur radio, un logement de récepteur radio, une armature d'éclairage, un logement de chargeur de batterie, un logement de batterie, un composant électrique d'automobile, un logement d'antenne, un logement de transformateur, un modem, une cartouche, un logement de dispositif d'interface de réseau, un logement de coupe-circuit, un logement de compteur, un panneau pour dispositif sec ou humide, un panneau de lave-vaisselle, un panneau d'appareil de lavage des vêtements, un panneau d'appareil de séchage des vêtements, un panneau de réfrigérateur, une enceinte de chauffage ou de ventilation, un ventilateur, un logement de climatiseur, un placage ou un siège pour le transport du public, ou un placage ou un siège pour les trains, le métro ou les autobus.

29. Procédé pour augmenter la température de déformation à chaud d'une composition résistant à l'inflammation, contenant une proportion d'un composé phosphorylé permettant d'attribuer à la composition un indice d'inflammabilité d'au moins V-2 selon le protocole UL-94 de Underwriter Laboratory, cet indice étant mesuré sur un échantillon pour essai de dimensions 3,2 mm x 12,7 mm x 127 mm (0,125 pouce x 0,5 pouce x 5 pouces), procédé qui comprend la combinaison de :
a) au moins un polyester carbonate renfermant des motifs de formule I : 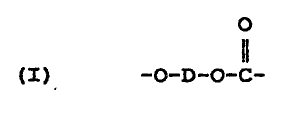 dans laquelle D représente un radical aromatique divalent, et des motifs revenant ou se répétant de formule II :
(II) -O-R¹-O-D-
dans laquelle D a la signification indiquée précédemment et R¹ représente au moins un groupe divalent choisi parmi les groupes de formules III et IV : 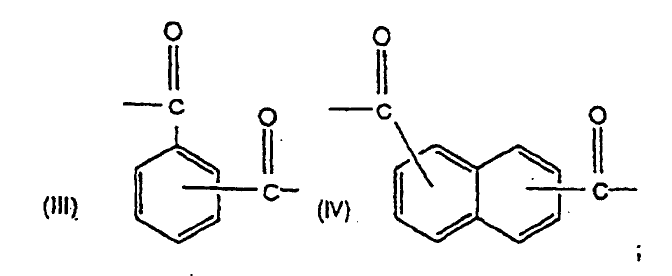
b) au moins un polymère d'addition, et
c) au moins un phosphoramide ayant un point de transition vitreuse d'au moins 0 °C et répondant à la formule V : 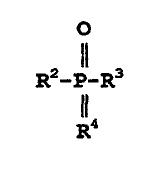 dans laquelle Q représente un atome d'oxygène, R² représente un reste aminé et R³ et R⁴ représentent chacun indépendamment un groupe alcoxy, alkylthio, aryloxy ou arylthio, ou un groupe aryloxy ou arylthio contenant au moins un groupe alkyle ou un atome d'halogène comme substituant, ou un mélange de ceux-ci, ou encore un reste aminé.

30. Procédé selon la revendication 29, dans lequel D comprend des motifs issus du bisphénol A.

31. Procédé selon la revendication 29, dans lequel D comprend des motifs issus du 6,6'-dihydroxy-3,3,3',3'-tétraméthyl-1,1'-spirobiindane.

32. Procédé selon la revendication 29, dans lequel R¹ comprend des motifs issus d'au moins l'un des composés suivants : acide isophtalique, acide téréphtalique et acide naphtalène-2,6-dicarboxylique.

33. Procédé selon la revendication 29, dans lequel R¹ comprend des motifs issus d'un mélange d'acide isophtalique et d'acide téréphtalique.

34. Procédé selon la revendication 33, dans lequel le rapport pondéral de l'acide isophtalique à l'acide téréphtalique est compris dans l'intervalle allant de 95:5 à 5:95.

35. Procédé selon la revendication 34, dans lequel le rapport pondéral de l'acide isophtalique à l'acide téréphtalique est compris dans l'intervalle allant de 93:7 à 50:50.

36. Procédé selon la revendication 29, dans lequel le rapport pondéral des motifs de formule I aux motifs de formule II est compris dans l'intervalle allant de 10:90 à 90:10.

37. Procédé selon la revendication 36, dans lequel le rapport pondéral des motifs de formule I aux motifs de formule II est compris dans l'intervalle allant de 20:80 à 40:60.

38. Procédé selon la revendication 29, dans lequel le polymère d'addition est un copolymère d'un composé alcénylaromatique.

39. Procédé selon la revendication 38, dans lequel le composé alcénylaromatique est le styrène.

40. Procédé selon la revendication 39, dans lequel le polymère d'addition est au moins un copolymère de styrène et d'acrylonitrile.

41. Procédé selon la revendication 40, dans lequel le polymère d'addition est une combinaison de deux copolymères de styrène et d'acrylonitrile.

42. Procédé selon la revendication 41, dans lequel l'un des copolymères de styrène et d'acrylonitrile est un copolymère ABS.

43. Procédé selon la revendication 29, qui comprend la combinaison de 55 à 95 % en poids de constituant polyestercarbonate et de 5 à 45 % en poids de polymère d'addition, ces pourcentages étant basés sur la totalité des constituants résineux.

44. Procédé selon la revendication 29, dans lequel le phosphoramide est un phosphoramide de formule XII : 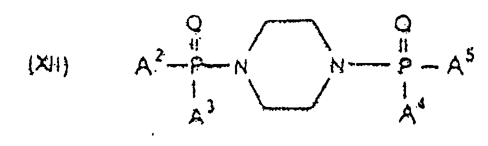 dans laquelle chaque Q représente un atome d'oxygène et chacun de A² à A⁵ représente un groupe 2,6-diméthylphénoxy ou 2,4,6-triméthylphénoxy.

45. Procédé selon la revendication 44, dans lequel le phosphoramide est un phosphoramide de formule XII : 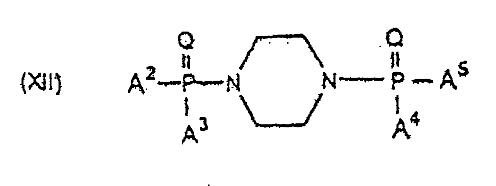 dans laquelle Q représente un atome d'oxygène et chacun de A² à A⁵ représente un groupe 2,6-diméthylphénoxy.

46. Procédé selon la revendication 29, dans lequel tous les phosphoramides ont un point de transition vitreuse d'au moins 0 °C.

47. Procédé selon la revendication 29, dans lequel R² répond à la formule XVI : 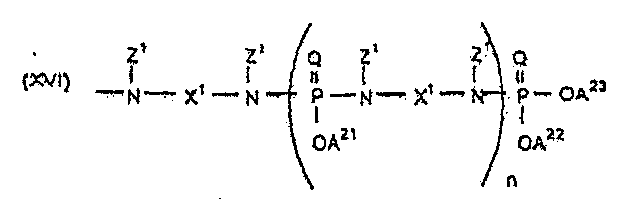 dans laquelle chaque Q représente un atome d'oxygène,
chacun de A²¹ à A²³ représente indépendamment un groupe alcoxy, alkylthio, aryloxy ou arylthio, ou un groupe aryloxy ou arylthio portant au moins un groupe alkyle comme substituant, ou encore un reste aminé,
chaque Z¹ représente un groupe alkyle, un groupe aromatique ou un groupe aromatique portant au moins un groupe alkyle comme substituant,
chaque X¹ représente un groupe alkylidène, un groupe aromatique ou un groupe aromatique portant au moins un groupe alkyle comme substituant,
et n est égal à 0 à 5,
et R³ et R⁴ représentent chacun indépendamment un groupe alcoxy, alkylthio, aryloxy ou arylthio, ou un groupe aryloxy ou arylthio portant au moins un groupe alkyle comme substituant, ou encore un reste aminé.

48. Procédé selon la revendication 29, dans lequel R² répond à la formule XVII : 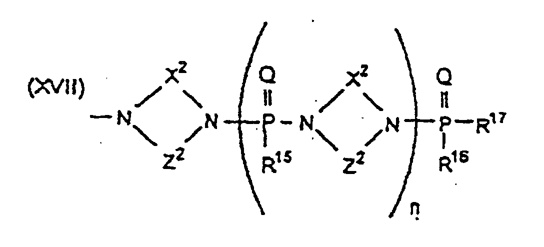 dans laquelle chaque Q représente un atome d'oxygène, chaque X² représente un groupe alkylidène, arylène ou alkarylène,
chaque Z² représente un groupe alkylidène, chacun de R¹⁵, R¹⁶ et R¹⁷ représente indépendamment un groupe alcoxy, aryloxy ou aryloxy portant au moins un groupe alkyle comme substituant, ou encore un reste aminé, et n est égal à 0 à 5,
et R³ et R⁴ représentent chacun indépendamment un groupe alcoxy, alkylthio, aryloxy ou arylthio, ou un groupe aryloxy ou arylthio portant au moins un groupe alkyle comme substituant, ou encore un reste aminé.

49. Procédé selon la revendication 29, dans lequel au moins un phosphoramide est présent en une proportion permettant d'attribuer à la composition à base de résine un indice d'inflammabilité de V-0, V-1 ou V-2 selon le protocole UL-94 de Underwriter Laboratory, cet indice étant mesuré sur un échantillon pour essai de dimensions 3,2 mm x 12,7 mm x 127 mm (0,125 pouce x 0,5 pouce x 5 pouces).

50. Procédé selon la revendication 29, dans lequel la quantité totale de phosphore est de 0,1 à 3 parties en poids pour 100 parties de matières résineuses.

51. Procédé selon la revendication 29, dans lequel la composition a un indice d'inflammabilité d'au moins V-1.

52. Procédé selon la revendication 29, dans lequel la composition a un indice d'inflammabilité d'au moins V-0.

53. Procédé selon la revendication 29, dans lequel la composition est essentiellement exempte de chlore et de brome.

54. La composition résistant à l'inflammation de la revendication 53.

55. La composition résistant à l'inflammation de la revendication 29.

56. Composition à base de résine, qui comprend les constituants suivants et tout produit de réaction de ces constituants :
a) au moins un polyestercarbonate renfermant des motifs de formule I : 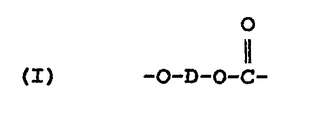 dans laquelle D représente un radical aromatique divalent, et des motifs revenant ou se répétant de formule II :
(II) -O-R¹-O-D-
dans laquelle D a la signification indiquée précédemment et R¹ représente au moins un groupe choisi parmi les groupes : 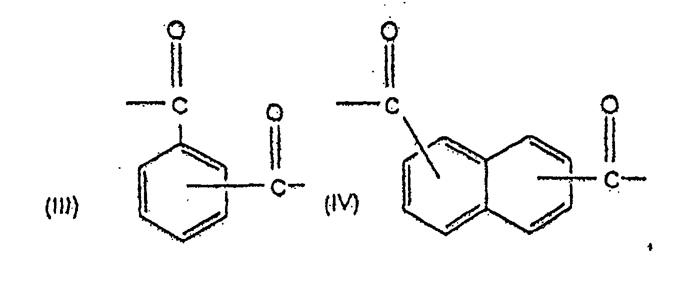
b) au moins un polymère d'addition, et
c) un phosphoramide ayant un point de transition vitreuse d'au moins 20 °C et répondant à la formule XII : 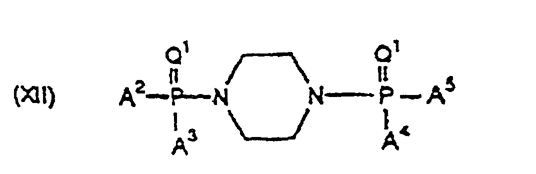 dans laquelle chaque Q¹ représente un atome d'oxygène et chaque A représente un groupe 2,6-diméthylphénoxy.

57. Composition selon la revendication 56, pour laquelle D renferme des motifs issus du bisphénol A.

58. Composition selon la revendication 56, pour laquelle R¹ renferme des motifs issus d'au moins l'un des composés suivants : acide isophtalique, acide téréphtalique et acide naphtalène-2,6-dicarboxylique.

59. Composition selon la revendication 56, dont le polymère d'addition est un copolymère d'un composé alcénylaromatique.

60. Composition selon la revendication 59, pour laquelle le composé alcénylaromatique est le styrène.

61. Composition selon la revendication 60, dont le polymère d'addition est au moins un copolymère de styrène et d'acrylonitrile.

62. Composition selon la revendication 61, dont le polymère d'addition est une combinaison de deux copolymères de styrène et d'acrylonitrile.

63. Composition selon la revendication 62, dont l'un des copolymères de styrène et d'acrylonitrile est un copolymère ABS.

64. Procédé pour augmenter la température de déformation à chaud d'une composition résistant à l'inflammation, contenant une proportion d'un phosphoramide permettant d'attribuer à la composition un indice d'inflammabilité d'au moins V-2 selon le protocole UL-94 de Underwriter Laboratory, cet indice étant mesuré sur un échantillon pour essai de dimensions 3,2 mm x 12,7 mm x 127 mm (0,125 pouce x 0,5 pouce x 5 pouces), procédé qui comprend la combinaison de :
a) au moins un polyestercarbonate renfermant des motifs de formule I : 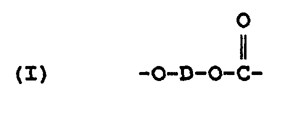 dans laquelle D représente un radical aromatique divalent, et des motifs revenant ou se répétant de formule II :
(II) -O-R¹-O-D-
dans laquelle D a la signification indiquée précédemment et R¹ représente au moins un groupe divalent choisi parmi les groupes de formules III et IV : 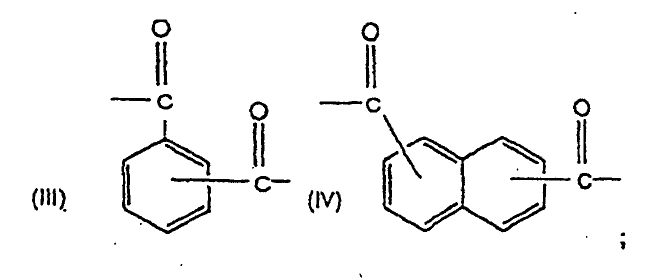
b) au moins un polymère d'addition, et
c) un phosphoramide ayant un point de transition vitreuse d'au moins 20 °C et répondant à la formule XII : 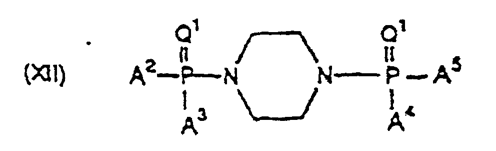 dans laquelle chaque Q¹ représente un atome d'oxygène et chaque A représente un groupe 2,6-diméthylphénoxy.

65. Composition selon la revendication 64, pour laquelle D renferme des motifs issus du bisphénol A.

66. Composition selon la revendication 64, pour laquelle R¹ renferme des motifs issus d'au moins l'un des composés suivants : acide isophtalique, acide téréphtalique et acide naphtalène-2,6-dicarboxylique.

67. Composition selon la revendication 64, dont le polymère d'addition est un copolymère d'un composé alcénylaromatique.

68. Composition selon la revendication 67, pour laquelle le composé alcénylaromatique est le styrène.

69. Composition selon la revendication 68, dont le polymère d'addition est au moins un copolymère de styrène et d'acrylonitrile.

70. Composition selon la revendication 69, dont le polymère d'addition est une combinaison de deux copolymères de styrène et d'acrylonitrile.

71. Composition selon la revendication 70, dont l'un des copolymères de styrène et d'acrylonitrile est un copolymère ABS.
